# EUROPEAN PATENT APPLICATION

(11) **EP 4 835 574 A1**
(43) Date of publication of application: **04.11.2026**
(21) Application number: 26174649.9
(22) Date of filing: 27.04.2026
(51) Int. Cl.: G03F 7/09

(54) **COMPOSITION FOR FORMING ORGANIC FILM AND PATTERNING PROCESS**

(30) Priority: 01.05.2025 JP 2025076187
(71) Applicant: Shin-Etsu Chemical Co., Ltd., Chiyoda-ku Tokyo 100-0005 (JP)
(72) Inventor: Kori, Daisuke, Niigata (JP); Iwamori, Shohei, Niigata (JP); Satoh, Hironori, Niigata (JP); Nakada, Seiya, Kubiki-ku Joetsu-shi (JP)
(74) Representative: Schicker, Silvia

(57) **Abstract**

The present invention is a composition for forming an organic film, containing: a polymer having, as a repeating unit, a unit represented by the following general formula (1); and an organic solvent, where "n1" represents 0 or 1, "n2" represents an integer of 1 to 3, R₁ represents a hydrogen atom or an alkynyl group having 2 to 4 carbon atoms, R₂ represents a hydrogen atom or a methyl group, R₃ represents a group selected from the following formulae (2), and AL₁ represents a leaving group that generates a hydroxy group by an action of heat or an acid. This can provide: a composition for forming an organic film, the composition being capable of exhibiting excellent planarizing property and excellent filling property and also being capable of forming an organic film having high resistance to twisting during etching.

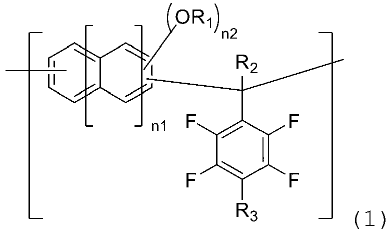

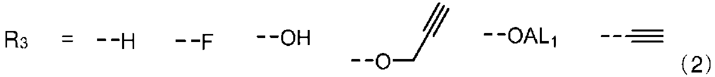

## Description

### TECHNICAL FIELD

The present invention relates to: a composition for forming an organic film for forming an organic film to be applied in fine processing in a manufacturing process of, for example, a semiconductor device etc.; and a patterning process, using the composition, suitable for exposure with, for example, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), extreme ultraviolet ray (EUV, 13.5 nm), electron beam (EB), or X-ray.

### BACKGROUND ART

As LSIs advance toward higher integration and higher processing speed, miniaturization of pattern rule is progressing rapidly. This is because the spread of high-speed communication of 5 G and artificial intelligence (AI) has progressed, and high-performance devices for processing these are needed. As a cutting-edge technology for miniaturization, 5-nm node devices have been mass-produced by extreme ultraviolet ray (EUV) lithography at a wavelength of 13.5 nm. Furthermore, studies are also in progress on employing EUV lithography in next-generation 3-nm node and the following-generation 2-nm node devices.

In a monolayer resist method, which is employed as a typical resist patterning process, as the thinning of resist patterns progresses as described above, pattern formation becomes difficult. It is known that, as a fine pattern processing method for solving such a problem, a multilayer resist method, in which a pattern is formed by laminating films having different dry etching properties for forming a pattern with a high aspect ratio on a stepped substrate, is excellent. As a multilayer resist method, for example, there has been developed and put to practical use, a 3-layer resist method in which a photoresist layer (hereinafter, resist upper layer film) made of an organic photosensitive polymer used in a monolayer resist method is combined with a middle layer (hereinafter, silicon-containing resist middle layer film) made of a silicon-based polymer or a silicon-based CVD film, and an underlayer made of an organic polymer (Patent Document 1).

This 3-layer resist method includes the following steps: firstly, a pattern is formed in a resist upper layer film; then, the pattern of the resist upper layer film is transferred to the silicon-containing resist middle layer film by using a fluorocarbon-based dry-etching gas; after that, while using the pattern as a mask, the pattern is transferred to an organic underlayer film mainly containing the elements carbon and hydrogen by dry etching using an oxygen-containing gas; and the pattern is formed on the substrate to be processed by dry etching while using the organic underlayer film having the transferred pattern as a mask. However, in a semiconductor device manufacturing process of the 20-nm generation and the further next generation, transferring the pattern to the substrate to be processed by dry etching while using the pattern of this organic underlayer film as a hard mask causes a phenomenon of twisting or bending of the organic underlayer film pattern.

A carbon hard mask formed immediately above the substrate to be processed is commonly an amorphous carbon (hereinafter, "CVD-C") film produced by a CVD method using methane gas, ethane gas, acetylene gas, etc. as a raw material. This CVD-C film, which can greatly reduce hydrogen atoms in the film, is known to be remarkably effective against the above twisting or bending of the pattern. However, it is also known that, when the substrate to be processed, being a base, has a step, it is difficult to fill such a step flatly because of characteristics of the CVD process. Thus, filling the stepped substrate to be processed with the CVD-C film and then patterning with a photoresist causes a step on the photoresist-coated surface due to the step of the substrate to be processed, causing ununiform film thickness of the photoresist, resulting in degradation of a focus margin and pattern shape during the lithography.

Meanwhile, it is known that, when an underlayer film as the carbon hard mask formed immediately above the substrate to be processed is formed by a spin-coating method, there is an advantage that the step of the stepped substrate can be flatly filled. When the substrate is planarized with this underlayer film material, it is possible to suppress fluctuation in the film thickness of the silicon-containing resist middle layer or photoresist formed thereon, making it possible to expand the focus margin of the lithography and form a regular pattern.

However, although a CVD-C film obtained using methane gas, ethane gas, acetylene gas, etc. as a raw material is an excellent film for forming an underlayer film having a uniform film thickness on a substrate, when there is a step on the substrate, an underlayer film having a flat surface cannot be formed unless the film thickness changes depending on the depth of the processed step. Therefore, the CVD-C film is not suitable as a means to planarize a stepped substrate.

In such a case, if an organic underlayer film (hereinafter, also referred to as an organic film) is formed as a resist underlayer film by spin-coating with a material for forming an underlayer film containing an organic resin, there is an advantage that, not only is it possible to fill the step of the substrate with the underlayer film material, the substrate surface can be planarized. However, although such an organic underlayer film has conventionally been used as an organic hard mask as a resist underlayer film in a multilayer resist process, the base material of the organic underlayer film is organic matter, and therefore, resistance to twisting at the time of fine pattern formation is insufficient compared to a CVD-C film. Accordingly, there are demands for an organic resin for an organic underlayer film, the resin having filling and planarizing properties as an organic hard mask while also having the same level of resistance to twisting as a CVD-C film. As approaches to improve twisting resistance, there have been studied: a method of increasing the carbon density of a resin used for the organic underlayer film; a method of adding fullerene (Patent Documents 2 and 3); a method of increasing the physical strength of the film (Patent Document 4); etc. However, these methods are still not substantial solutions.

Non Patent Document 1 suggests, as a mechanism of how twisting of a pattern occurs during etching, a mechanism caused by C-H bonds in the organic film being replaced by C-F bonds when the pattern is transferred to the organic underlayer film by using a fluorocarbon-based dry-etching gas. Meanwhile, Patent Document 5 proposes, as an organic underlayer film material into which fluorine atoms are introduced, a phenolic resin in which a fluorine substituent is introduced into benzaldehyde. However, even in these documents, there is no mention whatever of a solution that can achieve enhancement in resistance to twisting during etching while exhibiting excellent filling property and excellent planarizing property.

### CITATION LIST

### PATENT LITERATURE

Patent Document 1: JP2005-128509A
Patent Document 2: JP2010-122656A
Patent Document 3: WO2016/143436A1
Patent Document 4: JP2019-023251A
Patent Document 5: JP2024-147926A

### NON PATENT LITERATURE

Non Patent Document 1: Proc. of SPIE Vol. 6923 69232O-8

### SUMMARY OF INVENTION

### TECHNICAL PROBLEM

The present invention has been made to solve the above problems. An object of the present invention is to provide: a composition for forming an organic film, the composition being capable of exhibiting excellent planarizing property and excellent filling property and also being capable of forming an organic film having high resistance to twisting during etching; and a patterning process using such a composition for forming an organic film.

### SOLUTION TO PROBLEM

To achieve the object, the present invention provides a composition for forming an organic film, comprising:
a polymer having, as a repeating unit, a unit represented by the following general formula (1); and
an organic solvent, 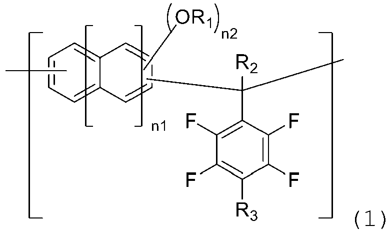
wherein "n1" represents 0 or 1, "n2" represents an integer of 1 to 3, R₁ represents a hydrogen atom or an alkynyl group having 2 to 4 carbon atoms, R₂ represents a hydrogen atom or a methyl group, and R₃ represents a group selected from the following formulae (2), 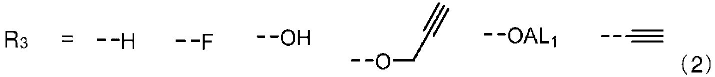
wherein AL₁ represents a leaving group that generates a hydroxy group by an action of heat or an acid.

An organic film formed from a composition for forming an organic film containing a polymer having a repeating unit represented by the general formula (1) has a repeating unit having a structure that contains substituting fluorine in advance, and therefore, when an organic film formed from the inventive composition for forming an organic film is used as an organic underlayer film, it is possible to suppress the fluorine substitution reaction of hydrogen atoms in the organic film, which is a factor that causes twisting during etching using a fluorine-based gas. As a result, the inventive composition for forming an organic film makes it possible to form an organic film having high resistance to twisting during etching. In addition, when the inventive composition for forming an organic film is applied onto a stepped body to be processed, the composition can fill the step of the body to be processed flatly. That is, the inventive composition for forming an organic film can exhibit excellent planarizing property and excellent filling property, and can also form an organic film having high resistance to twisting during etching.

The R₂ in the general formula (1) of the polymer is preferably a hydrogen atom.

In a polymer having such a partial structure (repeating unit), a hydrogen atom is present in a trityl position where three aromatic rings are adjacent to each other. Therefore, a crosslinking reaction is promoted by a coupling reaction accompanied by dehydrogenation during baking, and thus, the polymer is effective for forming a dense organic film. Moreover, there are few hydrogen atoms that may be substituted with fluorine atoms in a dehydrogenation reaction, and an organic film having stronger resistance to twisting can be formed, and therefore, the polymer is effective.

A number "n2" of a substituent represented by OR₁ in the general formula (1) of the polymer is preferably 2 or 3.

In a polymer having such a partial structure (repeating unit), by increasing the number of substituents OR₁ in such a range, not only is it possible to enhance the activity of the condensation reaction when the polymer is synthesized, an effect of reducing the hydrogen atoms on the aromatic ring that may be substituted with fluorine atoms during etching can also be expected. Furthermore, when R₁ is a hydrogen atom, a phenolic hydroxy group is formed, and reduction in hydrogen atoms on the aromatic ring and hydrogen atoms due to an oxidative coupling reaction accompanied by dehydration progressing can also be expected, and the polymer can exhibit a greater effect of achieving a strong resistance to twisting.

The group represented by the R₃ in the general formula (1) of the polymer is preferably selected from the following formulae (3).

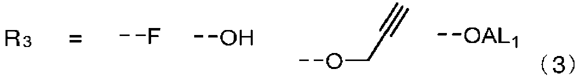

It is preferable that the polymer has such a partial structure R₃ from the viewpoint of controlling required properties of the organic film, such as curability and flatness. Any of the structures can be selected as the structure of the substituent in the polymer according to the required property, for example, a substituent for imparting flowability, a substituent for enhancing curability, a substituent for further reducing hydrogen atoms, etc. Furthermore, to achieve multiple properties, the above-described substituents can be used in combination.

The polymer preferably has a weight-average molecular weight of 2000 to 10000.

When the composition for forming an organic film contains a polymer having a weight-average molecular weight Mw within such a range, there is no risk of solubility in an organic solvent being degraded, and it is possible to suppress outgassing that accompanies sublimation caused by low molecular weight materials contained in the polymer during baking.

The organic solvent is preferably a mixture of one or more kinds of organic solvent having a boiling point of lower than 180°C and one or more kinds of organic solvent having a boiling point of 180°C or higher.

Such a composition for forming an organic film has both higher filling and planarizing properties by virtue of imparting thermal flowability of the film by adding the high-boiling-point solvent to the above-described polymer.

The composition for forming an organic film can further comprise one or more of a surfactant and a plasticizer.

A composition for forming an organic film containing such components can be provided with better coating property or better filling and planarizing properties.

The present invention also provides a patterning process of a first embodiment comprising:
forming an organic film on a body to be processed by using the inventive composition for forming an organic film;
forming a silicon-containing resist middle layer film on the organic film by using a silicon-containing resist middle layer film material;
forming a resist upper layer film on the silicon-containing resist middle layer film by using a photoresist composition;
forming a circuit pattern in the resist upper layer film;
transferring the pattern to the silicon-containing resist middle layer film by etching while using the resist upper layer film having the formed pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The present invention also provides a patterning process of a second embodiment comprising:
forming an organic film on a body to be processed by using the inventive composition for forming an organic film;
forming a silicon-containing resist middle layer film on the organic film by using a silicon-containing resist middle layer film material;
forming an organic antireflective coating on the silicon-containing resist middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the silicon-containing resist middle layer film by etching while using the resist upper layer film having the formed pattern as a mask;
transferring the pattern to the organic film by etching while using the silicon-containing resist middle layer film having the transferred pattern as a mask; and
further forming the pattern in the body to be processed by etching the body to be processed while using the organic film having the transferred pattern as a mask.

The present invention also provides a patterning process of a third embodiment comprising:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming a resist upper layer film on the inorganic hard mask by using a photoresist composition;
forming a circuit pattern in the resist upper layer film;
transferring the pattern to the inorganic hard mask by etching while using the resist upper layer film having the formed pattern as a mask;
transferring the pattern to the organic film by etching while using the inorganic hard mask having the transferred pattern as a mask; and
further forming the pattern in the body to be processed by etching the body to be processed while using the organic film having the transferred pattern as a mask.

The present invention also provides a patterning process of a fourth embodiment comprising:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming an organic antireflective coating on the inorganic hard mask;
forming a resist upper layer film on the organic antireflective coating by using a photoresist composition, so that a 4-layered film structure is constructed;
forming a circuit pattern in the resist upper layer film;
transferring the pattern to the organic antireflective coating and the inorganic hard mask by etching while using the resist upper layer film having the formed pattern as a mask;
transferring the pattern to the organic film by etching while using the inorganic hard mask having the transferred pattern as a mask; and
further forming the pattern in the body to be processed by etching the body to be processed while using the organic film having the transferred pattern as a mask.

When patterning is performed using the inventive composition for forming an organic film as an organic film material (resist underlayer film material) as described above, it is possible to transfer a pattern (circuit pattern) formed in an upper layer photoresist to the body to be processed with high precision and form a desired pattern. Furthermore, the inventive composition for forming an organic film can be used suitably for various patterning processes such as: a 3-layer resist process using a silicon-containing resist middle layer film or an inorganic hard mask; and a 4-layer resist process using an organic antireflective film in addition to these. In a process of manufacturing a semiconductor device, according to the inventive patterning processes described above, it is possible to prevent twisting of an organic film pattern even during etching using a fluorine gas, for example, and a fine pattern can be formed with high precision.

The inorganic hard mask can be formed by a CVD method or an ALD method.

In the inventive patterning process, the inorganic hard mask can be formed by such methods, for example.

The circuit pattern may be formed by a lithography using light with a wavelength of 10 nm or more to 300 nm or less, a direct drawing with electron beam, nanoimprinting, or a combination thereof.

Furthermore, the circuit pattern may be developed by alkali development or with an organic solvent.

In the inventive patterning process, such means for forming and developing the circuit pattern can be used suitably.

The body to be processed can be a semiconductor device substrate, a metal film, a metal carbide film, a metal oxide film, a metal nitride film, a metal oxycarbide film, or a metal oxynitride film.

In this case, the metal can be silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning process, such substrates to be processed can be processed to form a pattern.

### ADVANTAGEOUS EFFECTS OF INVENTION

As described above, the inventive composition for forming an organic film contains a polymer having multiple fluorine substituents in a repeating unit, and thus, it is possible to suppress the fluorination reaction of hydrogen atoms that occurs during etching. An organic film formed from the inventive composition for forming an organic film has a function of suppressing twisting of a pattern induced by change in the chemical structure during etching. Therefore, when the inventive composition for forming an organic film is used as a material for an organic film (organic underlayer film), the composition is useful for forming an organic film excellent in twisting resistance. Furthermore, a composition for forming an organic film containing such a polymer is a material useful for forming an organic film that not only has excellent twisting resistance and is also excellent in film strength, but also has various properties such as filling and planarizing properties. Therefore, the inventive composition for forming an organic film is extremely useful as a resist underlayer film material in multilayer resist processes, for example: a 2-layer resist process; a 3-layer resist process using a silicon-containing resist middle layer film or an inorganic hard mask; or a 4-layer resist process using a silicon-containing resist middle layer film or an inorganic hard mask and an organic antireflective coating.

Furthermore, according to the inventive patterning process, a fine pattern can be formed in a substrate to be processed with high precision in a multilayer resist process.

### BRIEF DESCRIPTION OF DRAWINGS

FIG. 1 is a schematic flow diagram showing an example of a 3-layer resist process, being an embodiment of an inventive patterning process.
FIG. 2 is a schematic cross-sectional view for explaining planarizing property evaluation in the Examples.

### DESCRIPTION OF EMBODIMENTS

As described above, there have been demands for the development of a composition for forming an organic film that can exhibit excellent planarizing and filling properties and can also form an organic film having high resistance to twisting during etching.

The present inventors have earnestly studied the problem, and found out that a composition for forming an organic film containing a polymer having, as a repeating unit, a unit represented by the general formula (1) can exhibit excellent planarizing and filling properties, and in addition, can suppress the fluorine substitution reaction of hydrogen atoms that occurs during etching, making it possible to form an organic film excellent in twisting resistance. Thus, the present invention has been completed.

That is, the present invention is a composition for forming an organic film, comprising:
a polymer having, as a repeating unit, a unit represented by the following general formula (1); and
an organic solvent, 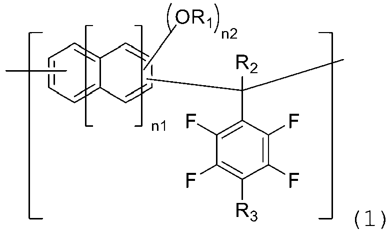
wherein "n1" represents 0 or 1, "n2" represents an integer of 1 to 3, R₁ represents a hydrogen atom or an alkynyl group having 2 to 4 carbon atoms, R₂ represents a hydrogen atom or a methyl group, and R₃ represents a group selected from the following formulae (2), 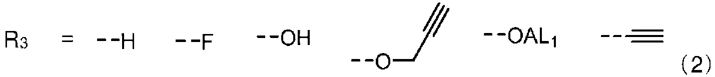
wherein AL₁ represents a leaving group that generates a hydroxy group by an action of heat or an acid.

Hereinafter, the present invention will be described in detail, but the present invention is not limited thereto. Note that, in the present description, both a moiety consisting of a single atom and a moiety consisting of a group of multiple atoms are referred to as a "group".

### [Composition for Forming Organic Film]

The inventive composition for forming an organic film contains: a polymer having, as a repeating unit, a unit represented by the general formula (1); and an organic solvent.

The present inventors have found out that, by reducing the hydrogen atoms in the organic film as much as possible, it is possible to suppress the substitution of hydrogen atoms with fluorine atoms during etching and suppress the twisting of the organic film. More specifically, the present inventors have considered that, based on the mechanism described in Non Patent Document 1, it means that twisting occurs due to hydrogen atoms in the resin being substituted with fluorine during etching. Accordingly, the present inventors have considered that twisting during etching can be suppressed efficiently by reducing the hydrogen atoms in the resin as much as possible and also fluorinating the resin beforehand to suppress alteration in the properties of the film that accompanies fluorination during etching. Based on this idea, the present inventors have prepared a composition for forming an organic film, containing a polymer having, as a repeating unit, a unit represented by the formula (1) and an organic solvent, and found out that such a composition can actually exhibit excellent planarizing and filling properties, and in addition can form an organic film in which the fluorinating reaction of hydrogen atoms that occurs during etching can be suppressed and which is excellent in twisting resistance.

Note that, although the inventive composition for forming an organic film contains a polymer having, as a repeating unit, a unit represented by the general formula (1) and an organic solvent as described earlier, the composition may further contain optional components besides such a polymer and organic solvent.

In the following, the essential components and optional components of the inventive composition for forming an organic film will be described in turn.

### <Polymer>

The polymer contained in the inventive composition for forming an organic film has, as a repeating unit, a unit represented by the following general formula (1). This polymer can, for example, be referred to as a polymer for forming an organic film.

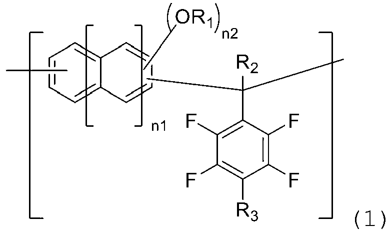

In the general formula (1), "n1" represents 0 or 1, "n2" represents an integer of 1 to 3, R₁ represents a hydrogen atom or an alkynyl group having 2 to 4 carbon atoms, R₂ represents a hydrogen atom or a methyl group, and R₃ represents a group selected from the following formulae (2).

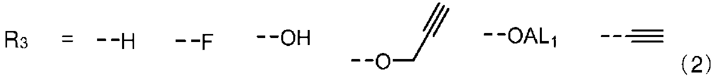

AL₁ represents a leaving group that generates a hydroxy group by an action of heat or an acid. A broken line represents an attachment point.

In the general formula (1), when "n2" is 2 or 3, the two or three groups R₁ may all be identical, or may include groups R₁ different from each other. Furthermore, the polymer contained in the inventive composition for forming an organic film can also include multiple kinds of units in which the group R₁, the group R₂, and/or the group R₃ are of different kinds.

As the leaving group AL₁ that generates a hydroxy group by an action of heat or an acid in the formula (2), it is possible to use, for example, an acid-labile group disclosed in JP2013-80033A or JP2013-83821A, but the leaving group is not limited thereto.

Specific examples of the acid-labile group include ones represented by the following formulae (AL-1) to (AL-3).

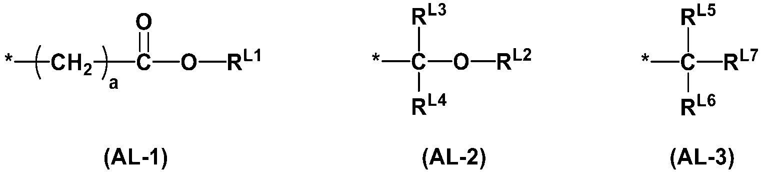

In the formulae, "*" represents an attachment point.

In the formulae (AL-1) and (AL-2), R^{L1} and R^{L2} each independently represent a hydrocarbyl group having 1 to 40 carbon atoms, and optionally contain a heteroatom such as an oxygen atom, a sulfur atom, a nitrogen atom, a fluorine atom, and an iodine atom. The hydrocarbyl group may be linear, branched, or cyclic. As the hydrocarbyl group, ones having 1 to 20 carbon atoms are preferable.

In the formula (AL-1), "a" is preferably an integer of 0 to 10, more preferably an integer of 1 to 5.

In the formula (AL-2), R^{L3} and R^{L4} each independently represent a hydrogen atom or a hydrocarbyl group having 1 to 20 carbon atoms and optionally containing a heteroatom such as an oxygen atom, a sulfur atom, a nitrogen atom, a fluorine atom, and an iodine atom. The hydrocarbyl group may be linear, branched, or cyclic. Furthermore, any two of R^{L2}, R^{L3}, and R^{L4} may be bonded to each other together with the carbon atom or the carbon atom and the oxygen atom bonded thereto to form a ring having 3 to 20 carbon atoms. As the ring, a ring having 4 to 16 carbon atoms is preferable, and an aliphatic ring is particularly preferable.

In the formula (AL-3), R^{L5}, R^{L6}, and R^{L7} each independently represent a hydrocarbyl group having 1 to 20 carbon atoms and optionally contain a heteroatom such as an oxygen atom, a sulfur atom, a nitrogen atom, a fluorine atom, and an iodine atom. The hydrocarbyl group may be linear, branched, or cyclic. Furthermore, any two of R^{L5}, R^{L6}, and R^{L7} may be bonded to each other together with the carbon atom bonded thereto to form a ring having 3 to 20 carbon atoms. As the ring, a ring having 4 to 16 carbon atoms is preferable, and an aliphatic ring is particularly preferable.

As the leaving group AL₁, the structure represented by (AL-3) is preferable among the above, and specific examples include the following structures.

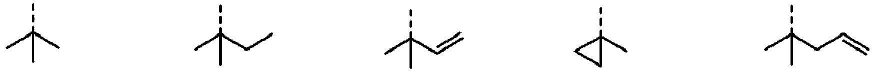

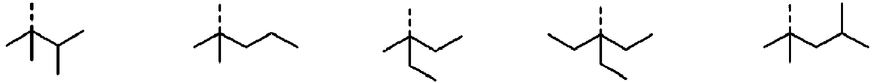

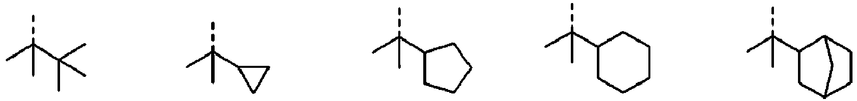

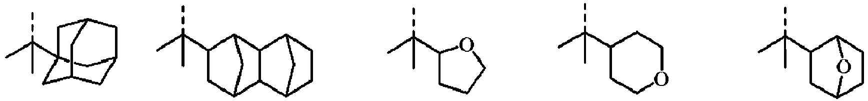

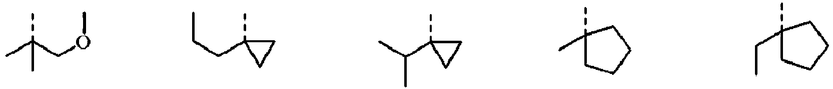

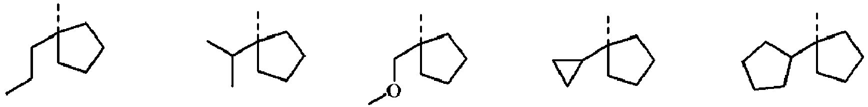

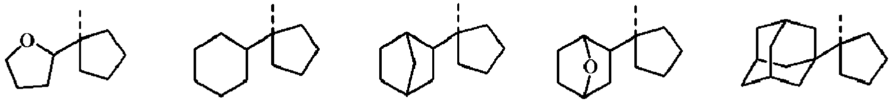

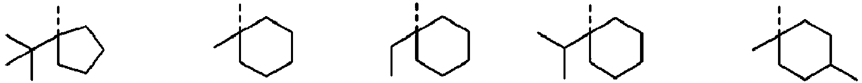

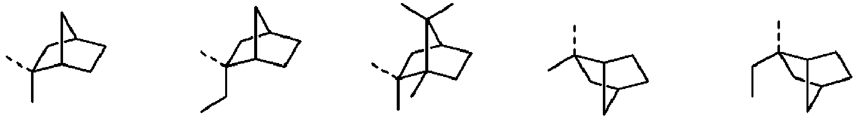

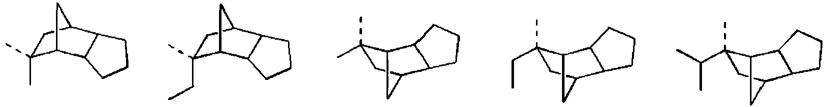

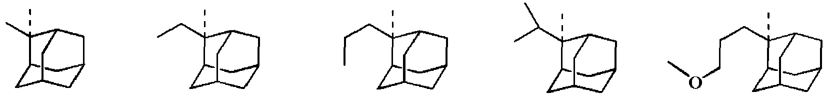

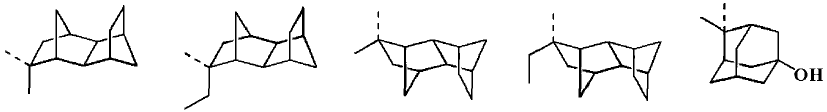

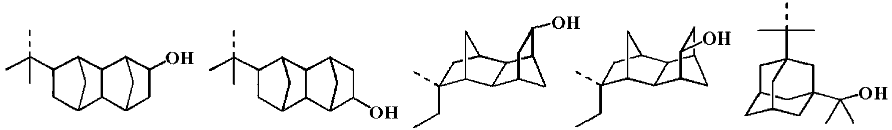

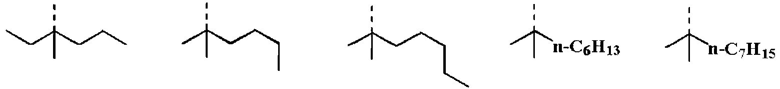

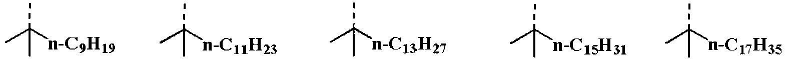

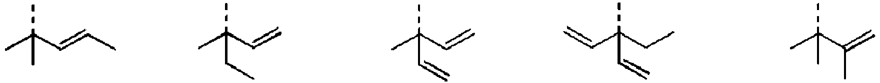

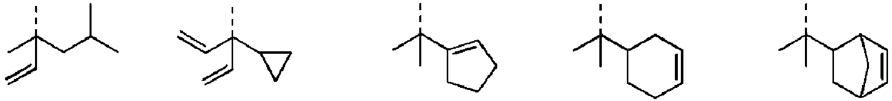

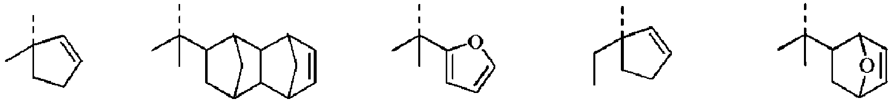

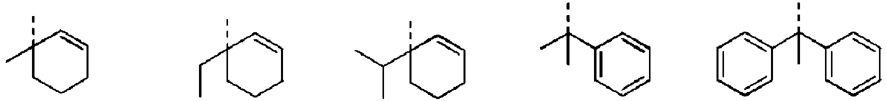

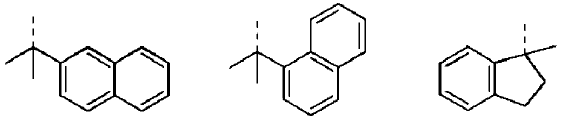

In the general formula (1), R₁ represents a hydrogen atom or an alkynyl group having 2 to 4 carbon atoms. The polymer contained in the inventive composition for forming an organic film can be roughly classified into polymers in which the group R₁ in the repeating unit of the general formula (1) is a hydrogen atom and polymers in which the group R₁ in the repeating unit of the general formula (1) is an alkynyl group.

### When Group R₁ in Repeating Unit of Polymer Represented by General Formula (1) Is Hydrogen Atom

When the group R₁ in the repeating unit of the polymer represented by the general formula (1) is a hydrogen atom, the polymer for forming an organic film is a so-called phenolic resin. The polymer can be obtained by a polycondensation reaction between a phenolic compound (when the substituent OR₁ of the aromatic ring structure having the group OR₁ as a substituent is a hydroxy group) and an aldehyde compound or a ketone compound (the aromatic ring structure having the groups R₂ and R₃ as partial structures).

The phenolic compound is a compound in which R₁ is a hydrogen atom, that is, a compound having a hydroxy group OH bonded to an aromatic ring, and specific examples thereof include the following. These aromatic rings may have a substituent, and when "n3" is the number of substituents on the aromatic ring, substituents can be introduced in the range of integers that satisfy 6-n2-n3 ≥ 2 when n1 = 0 and 8-n2-n3 ≥ 2 when n1 = 1. Examples of substituents on the aromatic ring include branched and linear alkyl groups having 1 to 6 carbon atoms, alkyloxy groups having 1 to 10 carbon atoms, alkenyloxy groups having 2 to 10 carbon atoms, a carboxy group, halogen atoms, a trifluoromethoxy group, a cyano group, and a nitro group.

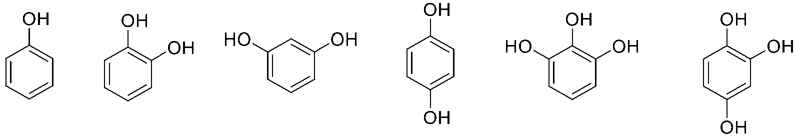

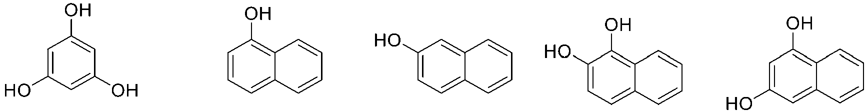

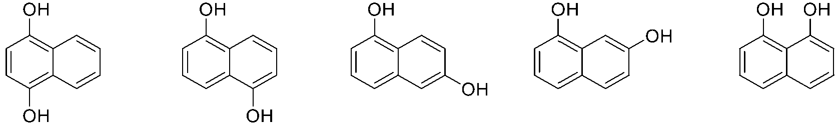

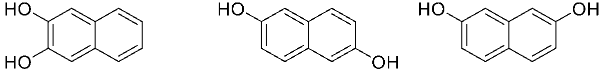

Among the above, it is preferable that the number "n2" of substituents represented by OR₁ is 2 or 3, that is, that the number of hydroxy groups on the aromatic ring is 2 or 3.

In a polymer having such a repeating unit, by increasing the number of substituents OR₁ in such a range, not only is it possible to enhance the activity of the condensation reaction when the polymer is synthesized, it is possible to suppress chemical change during etching, since the number of hydrogen atoms on the aromatic ring is reduced by the number of hydroxy groups increasing. Furthermore, when R₁ is a hydrogen atom, a phenolic hydroxy group is formed, and reduction in hydrogen atoms on the aromatic ring and hydrogen atoms due to the progress of an oxidative coupling reaction of the phenol in the film during baking accompanied by dehydration can also be expected, and the polymer can exhibit a greater effect of achieving a strong resistance to twisting. Therefore, such a case is more preferable. Furthermore, it is preferable that n1 = 0 and n2 = 2 or 3, or n1 = 1 and n2 = 2, and it is more preferable that, in addition, the hydroxy groups on the aromatic ring are not introduced to be adjacent to each other in the structure.

Examples of the aldehyde compound or the ketone compound include the following. R₂ and AL₁ are as defined above.

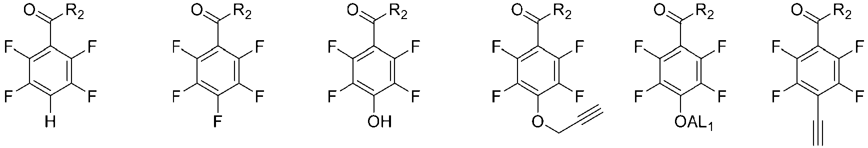

Among the above, it is preferable that R₂ is a hydrogen atom, that is, that the compound to react with the phenolic compound is an aldehyde compound. A polymer obtained by a reaction between such compounds includes a repeating unit represented by the general formula (1) in which the group R₂ is a hydrogen atom. In a polymer having such a repeating unit, a hydrogen atom is present in a trityl position where three aromatic rings are adjacent to each other. Therefore, a crosslinking reaction is promoted by a coupling reaction accompanied by dehydrogenation during baking, and thus, the polymer is effective for forming a dense organic film. Moreover, there are few hydrogen atoms that may be substituted with fluorine atoms in a dehydrogenation reaction, and an organic film having stronger resistance to twisting can be formed, and therefore, the polymer is effective.

Furthermore, it is more preferable that the substituent R₃ on the aldehyde is selected from the following formulae (3).

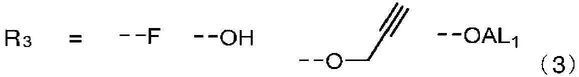

It is preferable that the polymer has such a substituent R₃ from the viewpoint of controlling required properties of the organic film, such as curability and flatness. Any of the structures can be selected as the structure of the substituent in the polymer according to the required property, for example, a substituent for imparting flowability, a substituent for enhancing curability, a substituent for further reducing hydrogen atoms, etc. Furthermore, to achieve multiple properties, the above-described substituents can be used in combination.

Among these, the group R₃ is more preferably a fluorine atom, a hydroxy group, or ···OAL₁. From the viewpoint of simplicity of production, the group R₃ is more preferably a fluorine atom or a hydroxy group.

### When Group R₁ in Repeating Unit of Polymer Represented by General Formula (1) Is Alkynyl Group

In this case, the group R₁ is an alkynyl group having 2 to 4 carbon atoms, and in the same manner as in the case where the R₁ of the polymer represented by the general formula (1) is a hydrogen atom, the polymer can be obtained by a polycondensation reaction between a compound in which the hydroxy group of a phenolic compound has been substituted with the substituent OR₁ and an aldehyde compound or a ketone compound (the aromatic ring structure having R₂ and R₃ as partial structures).

Examples of the alkynyl group having 2 to 4 carbon atoms represented by R₁ in this case include the following. Among these, from the viewpoints of the availability of raw materials, curability, etc., the group R₁ is preferably a propargyloxy group.

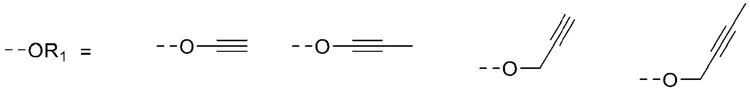

Specific examples of the compound in which the hydroxy group of a phenolic compound has been substituted with the substituent OR₁ include the following. These aromatic rings may have an additional substituent, and when "n3" is the number of additional substituents on the aromatic ring, additional substituents can be introduced in the range of integers that satisfy 6-n2-n3 ≥ 2 when n1 = 0 and 8-n2-n3 ≥ 2 when n1 = 1. Examples of additional substituents on the aromatic ring include branched and linear alkyl groups having 1 to 6 carbon atoms, alkyloxy groups having 1 to 10 carbon atoms, alkenyloxy groups having 2 to 10 carbon atoms, a carboxy group, halogen atoms, a trifluoromethoxy group, a cyano group, and a nitro group. R₁ is as defined above.

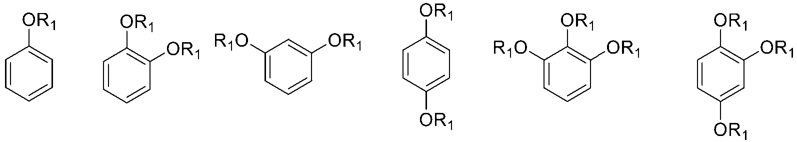

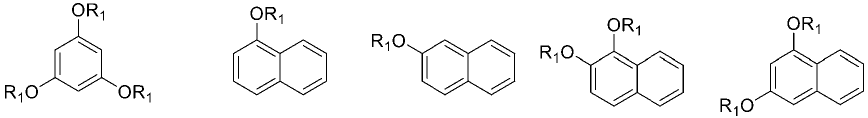

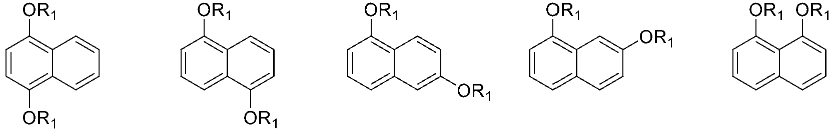

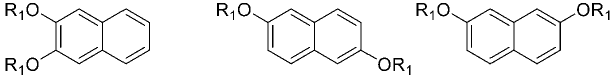

Among the above, regarding the number of substituents represented by OR₁, it is preferable that "n2" satisfies 2 or 3, that is, that the number of substituents OR₁ on the aromatic ring is 2 or 3 in the same manner as the number of hydroxy groups described earlier. Increasing the number of OR₁ groups to control curability makes it possible to lower the temperature of the baking performed to achieve the required curing, and furthermore, by end-capping the hydroxy group, it is possible to impart thermal flowability during baking. Furthermore, it is preferable that n1 = 0 and n2 = 2 or 3, or n1 = 1 and n2 = 2, and it is more preferable that, in addition, the hydroxy groups on the aromatic ring are not introduced to be adjacent to each other in the structure.

Examples of the aldehyde compound or the ketone compound include ones having the structures described earlier. Among the above, it is preferable that the group R₂ is a hydrogen atom, that is, the compound to react with the phenolic substituent is an aldehyde compound. A polymer obtained by a reaction between such compounds includes a repeating unit represented by the general formula (1) in which the group R₂ is a hydrogen atom. In a polymer including such a repeating unit, a hydrogen atom is present in a trityl position where three aromatic rings are adjacent to each other. Therefore, a crosslinking reaction is promoted by a coupling reaction accompanied by dehydrogenation during baking, and thus, the polymer is effective for forming a dense organic film. Moreover, there are few hydrogen atoms that may be substituted with fluorine atoms in a dehydrogenation reaction, and an organic film having stronger resistance to twisting can be formed, and therefore, the polymer is effective.

Furthermore, it is more preferable that the substituent R₃ on the aldehyde is selected from the formulae (3). It is preferable that the polymer has such a substituent R₃ from the viewpoint of controlling required properties of the organic film, such as curability and flatness. Any of the structures can be selected as the structure of the substituent in the polymer according to the required property, for example, a substituent for imparting flowability, a substituent for enhancing curability, a substituent for further reducing hydrogen atoms, etc. Furthermore, to achieve multiple properties, the above-described substituents can be used in combination. Among these, the group R₃ is preferably a fluorine atom, a hydroxy group, or ···OAL₁. From the viewpoint of simplicity of production, the group R₃ is more preferably a fluorine atom or a hydroxy group.

As an alternative example, the polymer contained in the inventive composition for forming an organic film may include a repeating unit in which the group R₁ of the general formula (1) is a hydrogen atom and a repeating unit in which the group R₁ of the general formula (1) is an alkynyl group. Such a polymer can be synthesized by, for example, the second example of the method for manufacturing a polymer described below.

Furthermore, the above-described polymer preferably has an Mw (weight-average molecular weight) of 2000 to 10000, and the Mw is further preferably 2000 to 5000.

When the polymer has a molecular weight within such a range, solubility in an organic solvent can be guaranteed, and sublimation products that are generated during baking can be suppressed. Furthermore, favorable thermal flowability of the polymer for forming an organic film can be achieved, and therefore, when the polymer is contained in a composition, not only is it possible favorably to fill a fine structure formed on a substrate, it is also possible to form an organic film that can planarize the entire substrate.

### <<First Example of Method for Manufacturing Polymer>>

The polymer that is contained in the inventive composition for forming an organic film and that has, as a repeating unit, a unit represented by the general formula (1) can be obtained by, as an example (first example) of a production method, a polycondensation reaction, shown in the following reaction formula, between an aromatic compound having the group OR₁ as a substituent and an aldehyde compound or a ketone compound as described above. R₁, R₂, R₃, "n1", and "n2" in the following formulae are as defined above.

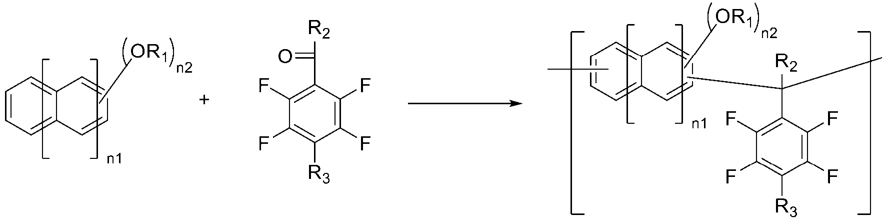

The polymer can usually be obtained in an organic solvent in the presence of an acid catalyst or a base catalyst at room temperature or under cooling or heating as necessary. Examples of acid catalysts that can be used include: inorganic acids, such as hydrochloric acid, hydrobromic acid, sulfuric acid, nitric acid, phosphoric acid, and heteropoly acid; organic acids, such as oxalic acid, trifluoroacetic acid, methanesulfonic acid, benzenesulfonic acid, p-toluenesulfonic acid, and trifluoromethanesulfonic acid; and Lewis acids, such as aluminum trichloride, aluminum ethoxide, aluminum isopropoxide, boron trifluoride, boron trichloride, boron tribromide, tin tetrachloride, tin tetrabromide, dibutyltin dichloride, dibutyltin dimethoxide, dibutyltin oxide, titanium tetrachloride, titanium tetrabromide, titanium (IV) methoxide, titanium (IV) ethoxide, titanium (IV) isopropoxide, and titanium (IV) oxide. Examples of base catalysts that can be used include: inorganic bases, such as sodium hydroxide, potassium hydroxide, barium hydroxide, sodium carbonate, sodium hydrogencarbonate, potassium carbonate, lithium hydride, sodium hydride, potassium hydride, and calcium hydride; alkyl metals, such as methyllithium, n-butyllithium, methylmagnesium chloride, and ethylmagnesium bromide; alkoxides, such as sodium methoxide, sodium ethoxide, and potassium t-butoxide; and organic bases, such as triethylamine, diisopropylethylamine, N,N-dimethylaniline, pyridine, and 4-dimethylaminopyridine. The amount of the catalyst to be used can be 0.001 to 100 mass%, preferably 0.005 to 50 mass% of the raw materials.

The polymer obtained by a polycondensation reaction using the above-described raw materials and catalysts can usually be obtained without a solvent or in a solvent while using an acid or a base as a catalyst at room temperature or under cooling or heating as necessary. Examples of the solvent used include: alcohols, such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers, such as diethyl ether, dibutyl ether, diethylene glycol diethyl ether, diethylene glycol dimethyl ether, tetrahydrofuran, and 1,4-dioxane; chlorine-based solvents, such as methylene chloride, chloroform, dichloroethane, and trichloroethylene; hydrocarbons, such as hexane, heptane, benzene, toluene, xylene, and cumene; nitriles, such as acetonitrile; ketones, such as acetone, ethyl methyl ketone, and isobutyl methyl ketone; esters, such as ethyl acetate, n-butyl acetate, and propylene glycol methyl ether acetate; lactones, such as γ-butyrolactone; and aprotic polar solvents, such as dimethyl sulfoxide, N,N-dimethylformamide, and hexamethylphosphoric triamide. One of these solvents may be used, or a mixture of two or more kinds thereof may be used.

These solvents can be used in an amount of 0 to 2,000 parts by mass based on 100 parts by mass of the reaction raw materials. The reaction temperature is preferably -50°C to approximately the boiling point of the solvent, further preferably room temperature to 150°C. Note that, in the present description, the boiling point of a solvent is the boiling point at the standard atmospheric pressure (1 atm = 1013.25 hPa).

The reaction method includes: a method where the above-described aromatic compound having the group OR₁ as a substituent and the aldehyde compound or the ketone compound are used as monomers and an acid catalyst as the catalyst is charged at once; a method where the monomers are dispersed or dissolved, and then the catalyst is added at once or in multiple batches or is diluted with a solvent and added dropwise; and a method where the catalyst is dispersed or dissolved, and then the monomers are added at once or in multiple batches or is diluted with a solvent and added dropwise. For the reaction, as each of the aromatic compound having the group OR₁ as a substituent and the aldehyde compound or the ketone compound, one kind or multiple kinds of each can be used. After the reaction has been completed, the resultant can be diluted in an organic solvent and then liquid-liquid separation washing can be performed to remove the catalyst used in the reaction, and thus, the target product can be collected.

The organic solvent to be used in liquid-liquid separation washing is not particularly limited, as long as the organic solvent is capable of dissolving the target product and is separated into two layers when mixed with water. Examples of the organic solvent include hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-t-butyl ether, and ethylcyclopentylmethyl ether; chlorinated solvents, such as methylene chloride, chloroform, dichloroethane, and trichloroethylene; mixtures thereof; etc. As washing water used in this event, generally, what is called deionized water or ultrapure water may be used. The washing may be performed one or more times, preferably approximately one to five times because washing ten times or more does not always produce the full washing effects thereof.

In the liquid-liquid separation washing, the washing may be performed with a basic aqueous solution to remove the acidic components in the system. Specific examples of the base include hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove the metal impurities or basic components in the system. Specific examples of the acid include inorganic acids, such as hydrochloric acid, hydrobromic acid, sulfuric acid, nitric acid, phosphoric acid, and heteropoly acid; organic acids, such as oxalic acid, fumaric acid, maleic acid, trifluoroacetic acid, methanesulfonic acid, benzenesulfonic acid, p-toluenesulfonic acid, and trifluoromethanesulfonic acid; etc.

The liquid-liquid separation washing may be performed with either one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or the acidic aqueous solution, washing with neutral water may be successively performed. The washing may be performed one or more times, preferably approximately one to five times. As the neutral water, deionized water, ultrapure water, or the like as mentioned above may be used. The washing may be performed one or more times, but if the washing is not performed sufficiently, the basic components and acidic components cannot be removed in some cases. The washing is preferably performed approximately one to five times because washing ten times or more does not always produce the full washing effects thereof.

Further, the reaction product after the liquid-liquid separation can also be collected as a powder by concentrating and drying up the solvent or crystallizing the reaction product under reduced pressure or normal pressure. Alternatively, the reaction product can also be retained in the state of solution with an appropriate concentration to improve the workability in preparing a composition for forming an organic film. The concentration in this event is preferably 0.1 to 50 mass%, more preferably 0.5 to 30 mass%. When the concentration is as described, the viscosity is hardly increased, and therefore, it is possible to prevent degradation of workability; in addition, since the amount of the solvent is not excessive, it is economical.

The solvent in this event is not particularly limited, as long as the solvent is capable of dissolving the polymer. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

### <<Alternative Method for Manufacturing Polymer (Second Example)>>

As an alternative manufacturing method in a case where the group R₁ in the general formula (1) of the polymer having the repeating unit represented by the general formula (1) and being contained in the inventive composition for forming an organic film is other than a hydrogen atom, the polymer can be obtained by the following method: a polymer to be an intermediate is obtained by a polycondensation reaction between a phenolic compound (when the OR₁ of the aromatic structure having OR₁ as a substituent is a hydroxy group) shown below and an aldehyde compound or a ketone compound (STEP 1-1), and subsequently, a substitution reaction in which the hydroxy group is substituted with the group OR₁ (R₁ is an alkynyl group) is performed using a raw material represented by R₁-X, having a leaving group X, and while using a base catalyst (STEP 2-1). In this case, one kind of compound represented by R₁-X may be used, or two or more kinds of compounds represented by R₁-X may be used, and furthermore, by controlling the reaction rate, it is also possible to control the proportions of the hydroxy group and the group OR₁. By controlling the reaction rate to introduce a polar structure, such as a hydroxy group, partially, it is also possible to control film-formability and adhesion of the film to a substrate. R₁, R₂, R₃, "n1", and "n2" are as defined above. Meanwhile, when R₃ is a hydroxy group, similarly, a reaction for forming an intermediate by a polycondensation reaction (STEP 1-2) and a subsequent substitution reaction (STEP 2-2) can be performed in the same manner. In this case, the reaction rate of the group OR₁ and R₃ can also be controlled, and by controlling the proportion of polar groups, it is possible to control film-formability and adhesiveness to a substrate or the like.

### (STEP1-1)

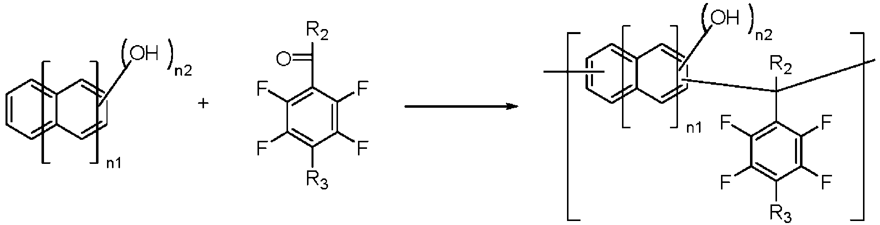

### (STEP2-1)

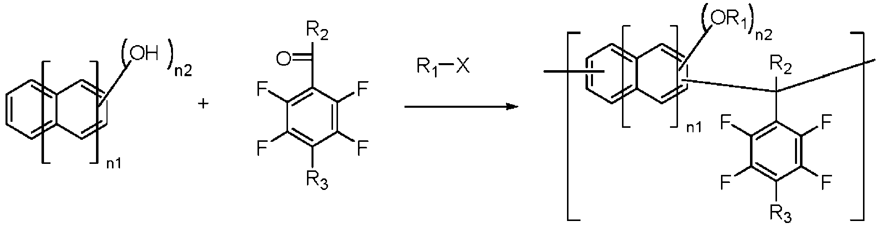

### (STEP1-2)

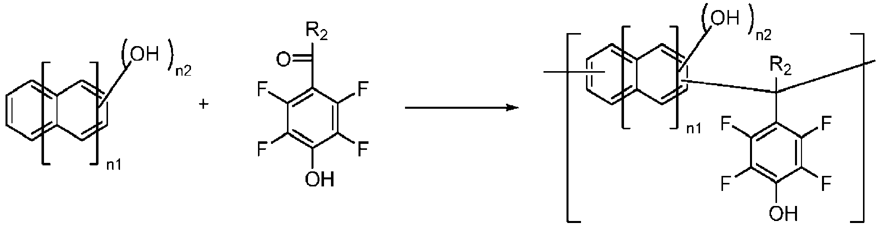

### (STEP2-2)

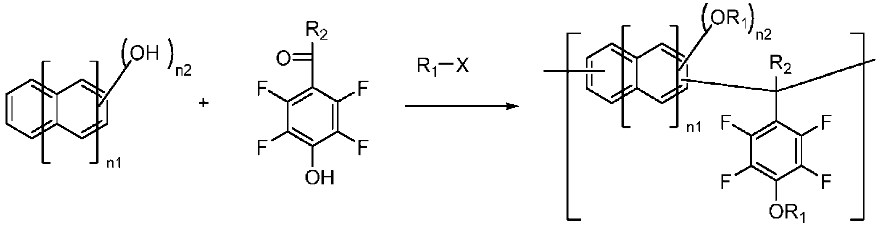

The polycondensation reaction of STEP 1-1 and STEP 1-2 and the method for collecting the polymer can be performed according to the method for manufacturing a polymer of the first example described earlier.

Examples of the base catalyst that can be used in the substitution reactions of STEP 2-1 and STEP 2-2 include inorganic base compounds, such as sodium hydrogen carbonate, sodium carbonate, potassium carbonate, calcium carbonate, cesium carbonate, sodium hydroxide, potassium hydroxide, sodium hydride, and potassium phosphate; and organic amine compounds such as triethylamine, pyridine, and N-methylmorpholine. One of these can be used, or two or more thereof may be used in combination. The amount is this catalyst to be used is, for example, 0.1 to 20 mol, preferably 0.2 to 10 mol based on the number of moles of the hydroxy groups of the polymers, being intermediates, obtained in STEP 1-1 and STEP 1-2.

The solvent used in this event is not particularly limited as long as the solvent is inactive in the above-described reaction. Examples of the solvent include: ether-based solvents, such as diethyl ether, tetrahydrofuran, and dioxane; aromatic solvents, such as benzene, toluene, and xylene; and acetonitrile, dimethyl sulfoxide, N,N-dimethylformamide, N-methylpyrrolidone, and water. One of these solvents may be used, or a mixture of two or more thereof may be used. These solvents can be used in a range of, for example, 0 to 2000 parts by mass based on 100 parts by mass of the polymer to be reacted, and the reaction temperature is preferably about -50°C to the boiling point of the solvent, further preferably room temperature to 150°C. The reaction time is appropriately selected from 0.1 to 100 hours, for example.

The reaction method and the method for collecting the polymer can be performed by the same methods as those in the method for manufacturing a polymer of the first example described earlier.

As described above, in the method for manufacturing the polymer contained in the inventive composition for forming an organic film, it is possible to control the reaction rate of the group OR₁ or the group R₃ in the reaction of the hydroxy group in STEP 2-1 and STEP 2-2 so as to achieve the desired performance. Specifically, when "a" is the proportion of hydroxy groups constituting the substituent OR₁ and the group R₃ in the polymer that are capable of reacting and "b" is the proportion of alkynyl groups having 2 to 4 carbon atoms, it is possible to adjust, at any proportion, hydrogen atoms, which can be expected to have an effect of imparting adhesiveness and film-formability to a substrate, and alkynyl groups having 2 to 4 carbon atoms, which can be expected to impart heat resistance and thermal flowability, and adjust the reaction rates in such a manner that a+b = 100(%) in accordance with the desired performance. When it is desired to impart thermal flowability, the proportion of alkynyl groups having 2 to 4 carbon atoms can be set to be higher than 50%, and when it is desired to enhance twisting resistance and film strength, the proportion of hydroxy groups can be set to be lower than 50%. Considering film-formability on a substrate and use in a 3-layer resist method, the proportion of alkynyl groups having 2 to 4 carbon atoms is preferably 0 to 90%, more preferably 0 to 80%.

Furthermore, in the preparation of the polymer to be contained in a composition for forming an organic film obtained by a method described above, one kind of various halides, tosylate, and mesylate or a combination of multiple kinds thereof can be used in according to the required performance. For example, it is possible to use, at any proportion, a combination including materials having a side-chain structure that contributes to the enhancement of planarizing property, a rigid aromatic ring structure that contributes to etching resistance and heat resistance, etc. Therefore, the inventive composition for forming an organic film containing these polymers can achieve both high filling and planarizing properties and etching resistance.

By containing the above-described polymer for forming an organic film, the inventive composition for forming an organic film can realize excellent twisting resistance, and moreover, by controlling the substituents of the polymer, the composition for forming an organic film can also realize excellent etching resistance and flatness.

Note that, in the inventive composition for forming an organic film, one kind of the polymer for forming an organic film can be used, or multiple kinds of the polymer for forming an organic film can be used in combination.

### <Organic Solvent>

The organic solvent usable in the inventive composition for forming an organic film is not particularly limited as long as the solvent is capable of dissolving the above-described polymer for forming an organic film and optional components (e. g. acid generator, crosslinking agent, other additives, etc. described later). The amount of the organic solvent contained is preferably 200 to 10,000 parts by mass, more preferably 300 to 5,000 parts by mass, based on 100 parts by mass of the polymer for forming an organic film.

Specifically, for example, it is possible to use solvents having a boiling point of lower than 180°C (which can also be referred to as low-boiling-point solvents) such as solvents disclosed in paragraphs

(0091) and (0092) of JP2007-199653A. In particular, preferably used are propylene glycol monomethyl ether acetate, propylene glycol monomethyl ether, 2-heptanone, cyclopentanone, cyclohexanone, and mixtures of two or more of these.

A composition containing such a low-boiling-point solvent can be applied by spin-coating, and furthermore, contains the above-described polymer for forming an organic film, and therefore, is a composition for forming an organic film having favorable twisting resistance at the time of dry etching as well as heat resistance and high filling and planarizing properties.

Furthermore, the inventive composition for forming an organic film may contain an organic solvent in which a high-boiling-point solvent having a boiling point of 180°C or higher is added to the aforementioned low-boiling-point solvent having a boiling point of lower than 180°C (a mixture of one or more organic solvents having a boiling point of lower than 180°C and one or more organic solvents having a boiling point of 180°C or higher). The high-boiling-point organic solvent is not particularly limited to hydrocarbons, alcohols, ketones, esters, ethers, chlorinated solvents, and so forth as long as the high-boiling-point solvent is capable of dissolving the compound for forming an organic film. Specific examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. As the high-boiling-point solvent, one of these may be used, or a mixture of two or more thereof may be used.

The boiling point of the high-boiling-point solvent may be appropriately selected according to the temperature at which the composition for forming an organic film is heated. The boiling point of the high-boiling-point solvent to be contained is preferably 180°C to 300°C, further preferably 200°C to 300°C. Such a boiling point prevents the evaporation rate at baking (heating) from becoming excessive, which would otherwise occur if the boiling point is too low. Thus, sufficient thermal flowability can be achieved. Meanwhile, with such a boiling point, the high-boiling-point solvent does not remain in the film without evaporating after baking because the boiling point is not too high. Thus, the boiling point in these ranges does not adversely affect the film physical properties, such as etching resistance.

When the high-boiling-point solvent is used, the contained amount of the high-boiling-point solvent is preferably 1 to 30 parts by mass based on 100 parts by mass of the low-boiling-point solvent having a boiling point of lower than 180°C. When the contained amount is as described, there is no risk of sufficient thermal flowability not being provided at the time of baking due to the contained amount being too small or risk of the solvent remaining in the film and causing degradation in film physical properties, such as etching resistance, due to the contained amount being too large.

In a composition for forming an organic film containing such a high-boiling-point solvent, the above-described compound for forming an organic film is provided with thermal flowability by the addition of the high-boiling-point solvent, so that the composition for forming an organic film also has high filling and planarizing properties.

### <Optional Components>

### (Compound or Polymer for Blending)

The inventive composition for forming an organic film can further contain a polymer (polymer for blending) other than the above-described polymer for forming an organic film or a compound for blending. The compound for blending or polymer for blending can be mixed with the polymer for forming an organic film of the present invention and, for example, can serve to improve the film-formability by spin-coating and the filling property for a stepped substrate. Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4' -(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, 7-methoxy-2-naphthol, dihydroxynaphthalene, such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fullerene resin compound disclosed in JP2008-158002A, etc. When the compound for blending or polymer for blending is contained, the contained amount is preferably 0 to 1,000 parts by mass, more preferably 0 to 500 parts by mass, based on 100 parts by mass of the polymer for forming an organic film.

### Acid Generator

In the inventive composition for forming an organic film, an acid generator can be contained so as to further promote the curing reaction. The acid generator includes a material that generates an acid by thermal decomposition and a material that generates an acid by light irradiation. Any acid generator can be contained. Specifically, materials disclosed in paragraphs (0061) to (0085) of JP2007-199653A can be contained, but the present invention is not limited thereto.

As the acid generator, one kind of compound may be used, or two or more kinds of compounds may be used in combination. When an acid generator is contained, the contained amount is preferably 0.05 to 50 parts, more preferably 0.1 to 10 parts, based on 100 parts of the above-described polymer.

### Surfactant

In the inventive composition for forming an organic film, a surfactant can be contained for improving coatability in spin-coating. As the surfactant, it is possible to use, for example, a surfactant disclosed in paragraphs (0142) to (0147) of JP2009-269953A. When a surfactant is contained, the contained amount is preferably 0.01 to 10 parts, more preferably 0.05 to 5 parts, based on 100 parts of the polymer.

### Crosslinking Agent

Moreover, in the inventive composition for forming an organic film, a crosslinking agent can also be contained so as to increase the curability to further suppress intermixing with an upper layer film. The crosslinking agent is not particularly limited, and known various types of crosslinking agents can be widely used. Examples thereof include polynuclear phenol-based, such as methylol or alkoxymethyl-based crosslinking agents, melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and epoxy-based crosslinking agents. When a crosslinking agent is contained, the contained amount is preferably 1 to 100 parts, more preferably 5 to 50 parts, based on 100 parts of the polymer.

Specific examples of the melamine-based crosslinking agents include hexamethoxymethylated melamine, hexabutoxymethylated melamine, alkoxy- and/or hydroxy-substituted derivatives thereof, and partial self-condensates thereof. Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof. Specific examples of the urea-based crosslinking agents include dimethoxymethylated dimethoxyethyleneurea, alkoxy- and/or hydroxy-substituted derivatives thereof, and partial self-condensates thereof. Specific examples of the β-hydroxyalkylamide-based crosslinking agents include N,N,N' ,N'-tetra(2-hydroxyethyl)adipic acid amide. Specific examples of the isocyanurate-based crosslinking agents include triglycidyl isocyanurate and triallyl isocyanurate. Specific examples of the aziridine-based crosslinking agents include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis(4,5-diphenyl-2-oxazoline), 2,2'-methylenebis (4-phenyl-2-oxazoline), 2,2'-methylenebis(4-tert-butyl-2-oxazoline), 2,2'-bis(2-oxazoline), 1, 3-phenylenebis(2-oxazoline), 1,4-phenylenebis(2-oxazoline), and a 2-isopropenyloxazoline copolymer. Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (4).

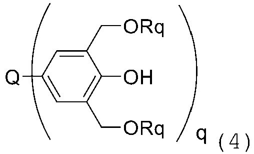

In the formula, Q represents a single bond or a q-valent hydrocarbon group having 1 to 20 carbon atoms. Rq represents a hydrogen atom or an alkyl group having 1 to 20 carbon atoms. "q" represents an integer of 1 to 5.

In the formula (4), Q represents a single bond or a hydrocarbon group having a valency of "q" and having 1 to 20 carbon atoms. "q" represents an integer of 1 to 5, more preferably 2 or 3. Specific examples of Q include groups each of which is obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or eicosane. Rq represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Rq is preferably a hydrogen atom or a methyl group.

Specific examples of the compound represented by the general formula (4) include the following compounds. In particular, from the viewpoints of enhancing the curability and film thickness uniformity of the organic film, hexamethoxymethylated derivatives of triphenolmethane, triphenolethane, 1,1,1-tris(4-hydroxyphenyl) ethane, and tris(4-hydroxyphenyl)-1-ethyl-4-isopropylbenzene are particularly preferable. Rq is as defined above.

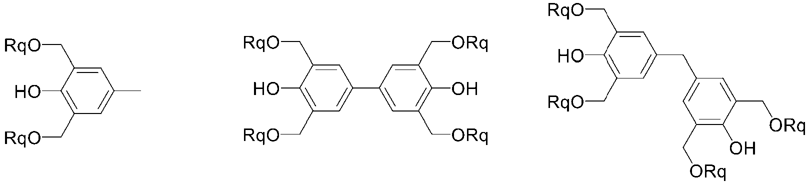

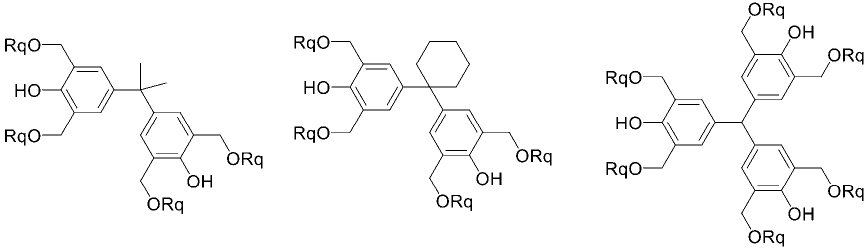

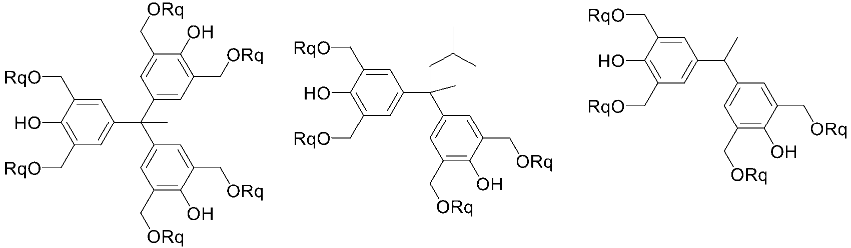

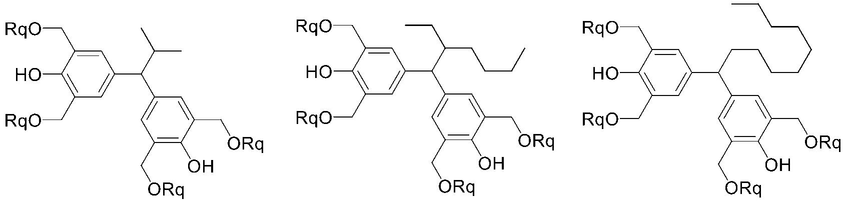

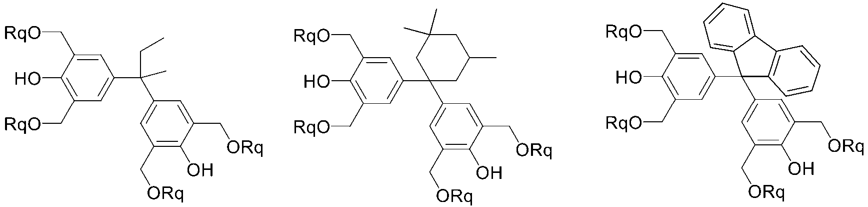

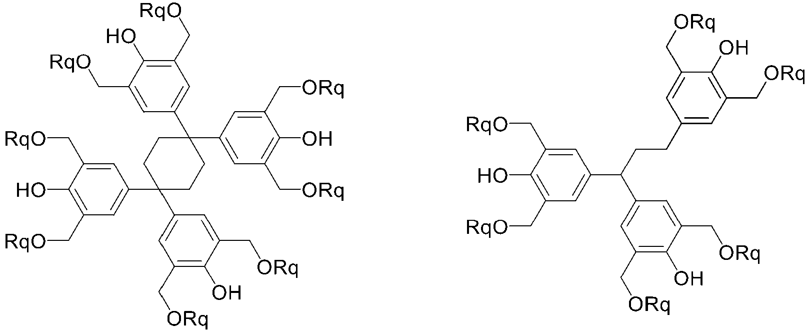

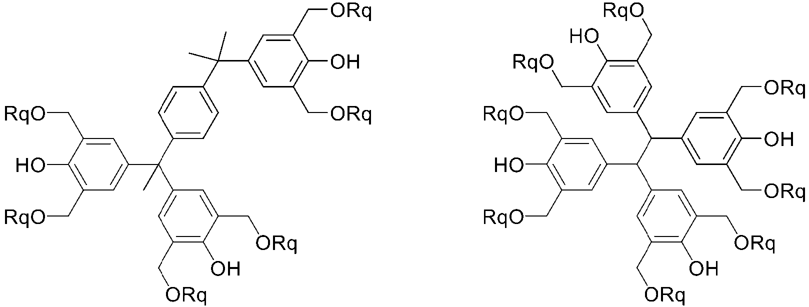

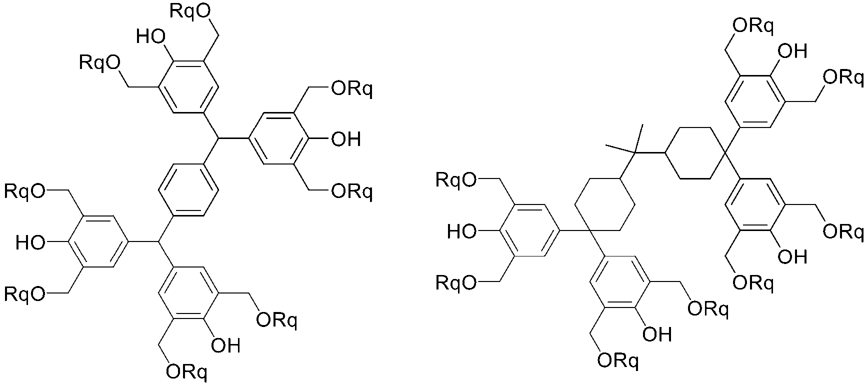

### Plasticizer

Further, in the inventive composition for forming an organic film, a plasticizer can be contained so as to further enhance the planarizing and filling properties. The plasticizer is not particularly limited, and known various types of plasticizers can be widely used. Examples thereof include low-molecular-weight compounds, such as phthalic acid esters, adipic acid esters, phosphoric acid esters, trimellitic acid esters, and citric acid esters; and polymers such as polyethers, polyesters, and polyacetal-based polymers disclosed in JP2013-253227A. When the plasticizer is contained, the contained amount is preferably 1 to 100 parts, more preferably 5 to 30 parts, based on 100 parts of the polymer.

### Additives

Particularly, like the plasticizer, as an additive for providing the inventive composition for forming an organic film with filling and planarizing properties, it is preferable to use, for example, liquid additives having polyethylene glycol or polypropylene glycol structures, or thermo-decomposable polymers whose weight reduction ratio on heating from 30°C to 250°C is 40 mass% or more, the polymers having a weight-average molecular weight of 300 to 200,000. The thermo-decomposable polymers preferably contain a repeating unit having an acetal structure shown by the following general formula (DP1) or (DP1a). When the thermo-decomposable polymer additives are contained, the contained amount is preferably 1 to 100 parts, more preferably 5 to 50 parts, based on 100 parts of the polymer.

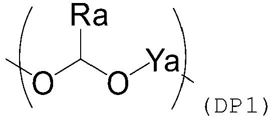

In the formula, Ra represents a hydrogen atom or a saturated or unsaturated monovalent organic group having 1 to 30 carbon atoms, the organic group optionally being substituted. Ya represents a saturated or unsaturated divalent organic group having 2 to 30 carbon atoms. 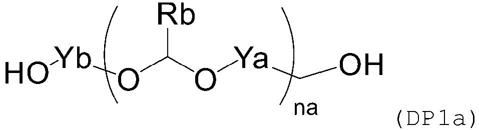 In the formula, Rb represents an alkyl group having 1 to 4 carbon atoms. Yb represents a saturated or unsaturated divalent hydrocarbon group having 4 to 10 carbon atoms and optionally having an ether bond. "na" represents an average repeating unit number of 3 to 500.

A composition for forming an organic film containing the surfactant and/or plasticizer can be provided with better coating property or better filling and planarizing properties.

The inventive composition for forming an organic film described in the above can be used as a resist underlayer film material or a planarizing material for manufacturing a semiconductor device.

In addition, the inventive composition for forming an organic film is extremely useful as a resist underlayer film material for multilayer resist processes such as a 2-layer resist process, a 3-layer resist process using a silicon-containing resist middle layer film or an inorganic hard mask, and a 4-layer resist process using a silicon-containing resist middle layer film or an inorganic hard mask and an organic antireflective coating.

### Method for Forming Organic Film

By using the inventive composition for forming an organic film, it is possible to form, for example: a resist underlayer film of a multilayer resist film used in lithography; or an organic film that functions as a planarizing film for manufacturing a semiconductor.

In the following, an example of a method for forming an organic film by using the inventive composition for forming an organic film will be described. However, methods for forming an organic film by using the inventive composition for forming an organic film are not limited to the examples described below.

In this method for forming an organic film, firstly, the inventive composition for forming an organic film described above is applied onto a substrate to be processed by spin-coating or the like. An excellent filling property can be obtained by using a spin-coating method. After the spin-coating, baking (heating) is performed in order to promote the crosslinking reaction to evaporate the solvent and prevent mixing with a resist upper layer film or a resist middle layer film. The baking is preferably performed at 100°C or higher and 600°C or lower for 10 to 600 seconds, more preferably at 200°C or higher and 500°C or lower for 10 to 300 seconds. Considering influence on device damage and wafer deformation, the upper limit of the heating temperature in a wafer process of lithography is preferably 600°C or lower, more preferably 500°C or lower.

In another example of a method for forming an organic film, the inventive composition for forming an organic film can be applied onto a substrate to be processed by spin-coating or the like in the same manner as above, and the organic film material can be cured by baking in an atmosphere having an oxygen concentration of 0.1% or more to 21% or less to form an organic film.

By baking the inventive composition for forming an organic film in such an oxygen atmosphere, a sufficiently cured film can be obtained. The atmosphere during the baking may be in air, but to prevent oxidization of the organic film, it is preferable to introduce an inert gas, such as N₂, Ar, and He to reduce oxygen. To prevent oxidization, it is necessary to control the oxygen concentration, and the concentration is preferably 1000 ppm or less, more preferably 100 ppm or less. When oxidization of the organic film during baking is prevented, there is no risk of increase in absorption or degradation in etching resistance, and this is preferable. This does not apply in a case where densification of the film occurs by virtue of an oxidization reaction using the oxygen in the air.

According to such a method for forming an organic film by using the inventive composition for forming an organic film, it is possible to obtain a flat cured film by virtue of the excellent filling and planarizing properties regardless of unevenness in the substrate to be processed, and therefore, the method is extremely useful when forming a flat cured film on a substrate to be processed having a structure or step having a height of 30 nm or more.

Incidentally, the thickness of the organic film, such as the resist underlayer film or the planarizing film for manufacturing a semiconductor device can be appropriately selected, and is preferably 30 to 20,000 nm, particularly preferably 50 to 15,000 nm.

### [Patterning Process]

The present invention provides, as an example of a patterning process according to a 3-layer resist process using such an organic film material, a patterning process including:
forming an organic film on a body to be processed by using the inventive composition for forming an organic film;
forming a silicon-containing resist middle layer film on the organic film by using a silicon-containing resist middle layer film material;
forming a resist upper layer film on the silicon-containing resist middle layer film by using a photoresist composition;
forming a circuit pattern in the resist upper layer film;
transferring the pattern to the silicon-containing resist middle layer film by etching while using the resist upper layer film having the formed pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

The silicon-containing resist middle layer film in the 3-layer resist process exhibits resistance to etching with an oxygen gas or a hydrogen gas, and therefore, in the 3-layer resist process, the dry etching of the organic film performed while using the silicon-containing resist middle layer film as a mask is preferably performed using an etching gas mainly containing an oxygen gas or a hydrogen gas.

As the silicon-containing resist middle layer film of the 3-layer resist process, a polysiloxane-based middle layer film is also favorably used. By providing the silicon-containing resist middle layer film with an antireflective effect, reflection can be suppressed. Particularly, for 193-nm light exposure, a material containing many aromatic groups and having high etching selectivity to a substrate is used as an organic film, so that the k-value and thus the substrate reflection are increased. However, the reflection can be suppressed by providing the silicon-containing resist middle layer film with absorption to achieve an appropriate k-value. Thus, the substrate reflection can be reduced to 0.5% or less. As the silicon-containing resist middle layer film having the antireflective effect, a polysiloxane is preferably used, the polysiloxane having anthracene for 248-nm and 157-nm light exposure, or a phenyl group or a light-absorbing group having a silicon-silicon bond for 193-nm light exposure in a pendant structure, and being crosslinked by an acid or heat.

Furthermore, an inorganic hard mask can be formed as a resist middle layer film, and as an example of such a case, the present invention provides a patterning process including:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming a resist upper layer film on the inorganic hard mask by using a photoresist composition;
forming a circuit pattern in the resist upper layer film;
transferring the pattern to the inorganic hard mask by etching while using the resist upper layer film having the formed pattern as a mask;
transferring the pattern to the organic film by etching while using the inorganic hard mask having the transferred pattern as a mask; and
further forming the pattern in the body to be processed by etching the body to be processed while using the organic film having the transferred pattern as a mask. Thus, a semiconductor device circuit pattern, for example, can be formed in a body to be processed, being a substrate, for example.

As described above, when an inorganic hard mask is to be formed on the organic film, it is possible to form a silicon oxide film, a silicon nitride film, or a silicon oxynitride film (SiON film) by a CVD method, an ALD method, or the like. For example, the method for forming the silicon nitride film is disclosed in JP2002-334869A and WO2004/066377A1. The film thickness of the inorganic hard mask is preferably 5 to 200 nm, more preferably 10 to 100 nm. Furthermore, as the inorganic hard mask, a SiON film is most preferably used, being effective as an antireflective coating. When the SiON film is formed, the substrate temperature reaches 300 to 500°C. Hence, the underlayer film needs to withstand the temperature of 300 to 500°C. The organic film material used in the present invention has high heat resistance and can withstand high temperatures of 300°C to 500°C, and this enables the combination of the inorganic hard mask formed by a CVD method or an ALD method with the organic film formed by a spin-coating method.

The inventive composition is also suitable for a 4-layer resist process using an organic antireflective coating (BARC), and as an example of such a case, the present invention provides a patterning process including:
forming an organic film on a body to be processed by using the inventive composition for forming an organic film;
forming a silicon-containing resist middle layer film on the organic film by using a silicon-containing resist middle layer film material;
forming an organic antireflective coating on the silicon-containing resist middle layer film;
forming a resist upper layer film on the organic antireflective coating by using a photoresist composition, so that a 4-layered film structure is constructed;
forming a circuit pattern in the resist upper layer film by, for example, exposing a pattern circuit region of the resist upper layer film and then developing with a developer;
transferring the pattern to the organic antireflective coating and the silicon-containing resist middle layer film by etching while using the resist upper layer film having the formed pattern as a mask;
transferring the pattern to the organic film by etching while using the silicon-containing resist middle layer film having the transferred pattern as a mask; and
further forming the pattern in the body to be processed by etching the body to be processed while using the organic film having the transferred pattern as a mask.

Alternatively, the present invention provides a patterning process including:
forming an organic film on a body to be processed by using the inventive composition for forming an organic film;
forming an inorganic hard mask selected from the group consisting of a silicon oxide film, a silicon nitride film, and a silicon oxynitride film on the organic film;
forming an organic antireflective coating on the inorganic hard mask;
forming a resist upper layer film on the organic antireflective coating by using a photoresist composition, so that a 4-layered film structure is constructed;
forming a circuit pattern in the resist upper layer film by, for example, exposing a pattern circuit region of the resist upper layer film and then developing with a developer;
transferring the pattern to the organic antireflective coating and the inorganic hard mask by etching while using the resist upper layer film having the formed pattern as a mask;
transferring the pattern to the organic film by etching while using the inorganic hard mask having the transferred pattern as a mask; and
further forming the pattern in the body to be processed by etching the body to be processed while using the organic film having the transferred pattern as a mask.

As described above, a photoresist film may be formed as a resist upper layer film on a silicon-containing resist middle layer film or an inorganic hard mask, or an organic antireflective coating (BARC) may be formed on the inorganic hard mask by spin-coating, and the photoresist film may be formed thereon. Particularly, when the SiON film is used as the inorganic hard mask, two layers of antireflective coating including the SiON film and the BARC make it possible to suppress the reflection even in liquid immersion exposure at a high NA exceeding 1.0. Another merit of the BARC formation is having an effect of reducing footing of the photoresist pattern immediately above the SiON film.

The resist upper layer film in the 3-layer or 4-layer resist process may be a positive type or a negative type, and any generally-used photoresist composition can be employed. After the spin-coating with the photoresist composition, pre-baking is performed, and the pre-baking is preferably performed at 60 to 180°C for 10 to 300 seconds. Then, light exposure, post-exposure baking (PEB), and development are performed according to conventional methods. Note that the thickness of the resist upper layer film is not particularly limited, but is preferably 30 to 500 nm, and particularly preferably 50 to 400 nm.

In the formation of the circuit pattern, the circuit pattern can be formed, for example, by a lithography using light with a wavelength of 10 nm or more to 300 nm or less, a direct drawing with electron beam, nanoimprinting, or a combination thereof. Furthermore, in the formation of the circuit pattern, the circuit pattern can be developed by alkali development or with an organic solvent.

Examples of the exposure light include high-energy beams with a wavelength of 300 nm or less; specifically, excimer lasers of 248 nm, 193 nm, and 157 nm, soft X-ray of 3 to 20 nm, electron beam, X-ray, etc.

Next, the silicon-containing resist middle layer film or the inorganic hard mask and the organic antireflective coating (when formed) are etched while using the obtained resist pattern as a mask. The etching of the silicon-containing resist middle layer film or the inorganic hard mask in the 3-layer resist process is performed using a fluorocarbon-based gas while using the upper layer resist pattern as a mask. Thereby, a silicon-containing resist middle layer film pattern or an inorganic hard mask pattern is formed.

Next, the organic film is etched while using the obtained silicon-containing resist middle layer film pattern or inorganic hard mask pattern as a mask.

The subsequent etching of the body to be processed can also be performed according to a conventional method. For example, the body to be processed made of SiO₂, SiN, or silica-based low-dielectric insulating film is etched mainly with a fluorocarbon-based gas. The body to be processed made of p-Si, Al, or W is etched mainly with a chlorine- or bromine-based gas. When the body to be processed is processed by etching with a fluorocarbon-based gas, the silicon-containing resist middle layer film pattern in the 3-layer resist process is removed together with the processing of the body to be processed. When the substrate is etched with a chlorine- or bromine-based gas, the removal of the silicon-containing resist middle layer film pattern needs to be performed by additional dry etching removal with a fluorocarbon-based gas after the processing of the body to be processed.

As explained earlier, an organic film obtained from the inventive composition for forming an organic film has a characteristic of having excellent resistance to twisting during these processes of etching the body to be processed. Therefore, according to the inventive patterning processes, it is possible to prevent twisting occurring in an organic film pattern during etching of the body to be processed, and as a result, the circuit pattern can be transferred to the body to be processed more accurately.

Incidentally, the body to be processed is not particularly limited, and it is possible to use substrates made of Si, α-Si, p-Si, SiO₂, SiN, SiON, W, TiN, Al, or the like; the substrate coated with a layer to be processed; etc. Examples of the layer to be processed include: various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, in particular, 100 to 5,000 nm. Note that when the layer to be processed is formed, the substrate and the layer to be processed are formed from different materials.

From another aspect, the body to be processed can be a semiconductor device substrate, a metal film, a metal carbide film, a metal oxide film, a metal nitride film, a metal oxycarbide film, or a metal oxynitride film. Furthermore, the metal can be silicon, titanium, tungsten, hafnium, zirconium, chromium, germanium, copper, silver, gold, aluminum, indium, gallium, arsenic, palladium, iron, tantalum, iridium, molybdenum, or an alloy thereof.

Furthermore, as the body to be processed, a substrate to be processed having a structure or step with a height of 30 nm or more is preferably used.

As explained earlier, the inventive composition for forming an organic film can exhibit excellent planarizing property and excellent filling property, and therefore, it is possible to fill the structure or step favorably and form an organic film that exhibits excellent flatness even in the case of a substrate to be processed having a structure or step having a height of 30 nm or more.

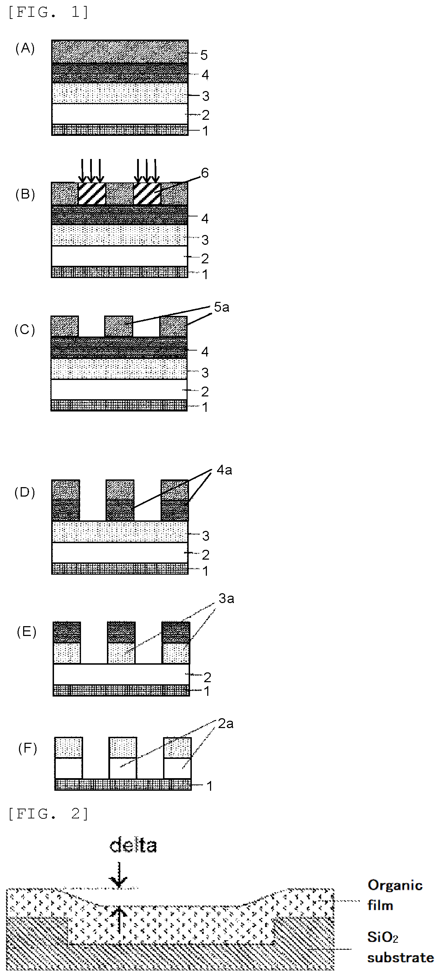

An example of a 3-layer resist process is specifically described with reference to FIG. 1 as follows. In the case of a 3-layer resist process, as shown in FIG. 1 (A), an organic film 3 is formed on a layer 2 to be processed laminated on a substrate 1 by using the inventive composition for forming an organic film, then a silicon-containing resist middle layer film 4 is formed, and a resist upper layer film 5 is formed thereon.

Subsequently, as shown in FIG. 1 (B), a required portion 6 of the resist upper layer film is exposed to light, followed by PEB and development to form a resist pattern 5a (FIG. 1 (C)). While using this obtained resist pattern 5a as a mask, the silicon-containing resist middle layer film 4 is etched using a CF-based gas to form a silicon-containing resist middle layer film pattern 4a (FIG. 1 (D)). The resist pattern 5a is removed, and then, which using this obtained silicon-containing resist middle layer film pattern 4a as a mask, the organic film 3 is etched with oxygen plasma to form an organic film pattern 3a (FIG. 1 (E)). Furthermore, the silicon-containing resist middle layer film pattern 4a is removed, and then, while using the organic film pattern 3a as a mask, the layer 2 to be processed is etched to form a pattern 2a (FIG. 1 (F)).

In the case where an inorganic hard mask is used, the silicon-containing resist middle layer film 4 can be replaced with the inorganic hard mask. In the case where a BARC is formed, the BARC layer is provided between the silicon-containing resist middle layer film 4 and the resist upper layer film 5. The BARC may be etched continuously and before the etching of the silicon-containing resist middle layer film 4. Alternatively, after the BARC is etched alone, the silicon-containing resist middle layer film 4 may be etched, for example, after an etching apparatus is changed.

As described above, according to the inventive patterning processes, it is possible to form a fine pattern in a body to be processed with high precision in a multilayer resist process.

### EXAMPLES

Hereinafter, the present invention will be more specifically described with reference to Synthesis Examples, Comparative Synthesis Examples, Examples, and Comparative Examples. However, the present invention is not limited thereto. Note that, with respect to molecular weight and dispersity, weight-average molecular weight (Mw) and number-average molecular weight (Mn) were measured by gel permeation chromatography (GPC) using tetrahydrofuran as an eluent in terms of polystyrene, and dispersity (Mw/Mn) was calculated on the basis of the molecular weights Mw and Mn.

### Synthesis Examples: Synthesis of Polymers for Forming Organic Film

For the synthesis of polymers (A1) to (A25) to be used for compositions for forming an organic film of the Examples, the aromatic compounds B ((a1) to (a8)) and aromatic aldehyde compounds C ((b1) to (b6)) shown below were used.

### Aromatic compounds B:

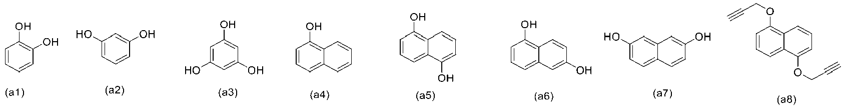

### Aromatic aldehyde compounds C:

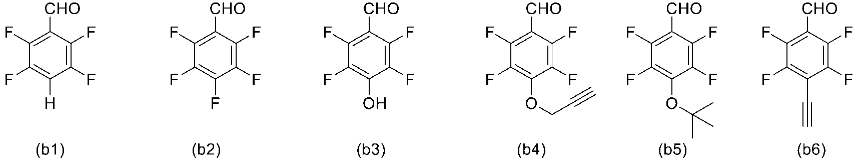

### Synthesis Example 1

### Synthesis of Polymer (A1)

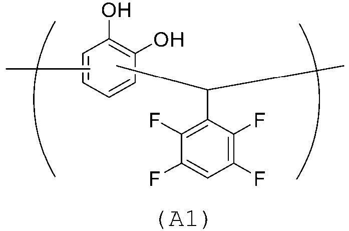

Under a nitrogen atmosphere, 22.0 g of the compound (a1), 19.2 g of methanesulfonic acid, and 100 g of 1,2-dichloroethane were mixed together to form a homogeneous solution at a solution temperature of 70°C. After that, 32.1 g of the compound (b1) was slowly added to the homogeneous solution, and the mixture was stirred for 8 hours at a solution temperature of 80°C. The mixture was cooled to room temperature, and then 200 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A1). When the weight-average molecular weight (Mw) and dispersity (Mw/Mn) were measured by GPC, the results were as follows: Mw=3700, Mw/Mn=2.17.

### Synthesis Example 2

### Synthesis of Polymer (A2)

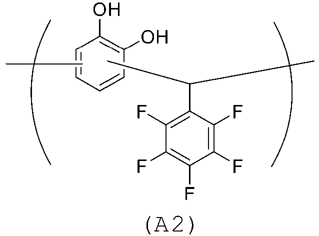

Under a nitrogen atmosphere, 22.0 g of the compound (a1), 19.2 g of methanesulfonic acid, and 150 g of 1,2-dichloroethane were mixed together to form a homogeneous dispersion at a solution temperature of 70°C. After that, 35.3 g of the compound (b2) was slowly added to the dispersion, and the mixture was stirred for 8 hours at a solution temperature of 80°C. The mixture was cooled to room temperature, and then 300 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A2). When the weight-average molecular weight (Mw) and dispersity (Mw/Mn) were measured by GPC, the results were as follows: Mw=3500, Mw/Mn=2.24.

### Synthesis Example 3

### Synthesis of Polymer (A3)

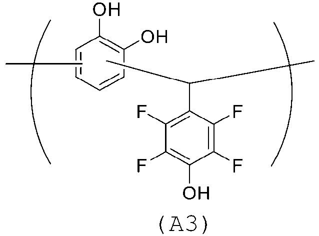

Under a nitrogen atmosphere, 22.0 g of the compound (a1), 19.2 g of methanesulfonic acid, and 150 g of 1,2-dichloroethane were mixed together to form a homogeneous dispersion at a solution temperature of 70°C. After that, a solution prepared beforehand by dissolving 34.9 g of the compound (b3) in 70 g of 1, 2-dichloroethane was slowly added to the dispersion, and the mixture was stirred for 8 hours at a solution temperature of 80°C. The mixture was cooled to room temperature, and then 300 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A3). When the weight-average molecular weight (Mw) and dispersity (Mw/Mn) were measured by GPC, the results were as follows: Mw=2900, Mw/Mn=2.01.

### Synthesis Example 4

### Synthesis of Polymer (A4)

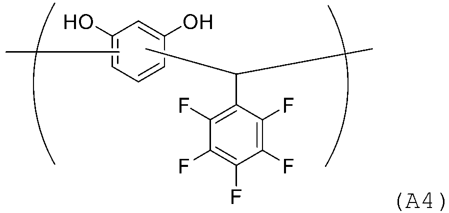

Under a nitrogen atmosphere, 22.0 g of the compound (a2), 35.3 g of the compound (b2), and 200 g of propylene glycol monomethyl ether (PGME) were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A4). When the weight-average molecular weight (Mw) and dispersity (Mw/Mn) were measured by GPC, the results were as follows: Mw=2100, Mw/Mn=1.88.

### Synthesis Example 5

### Synthesis of Polymer (A5)

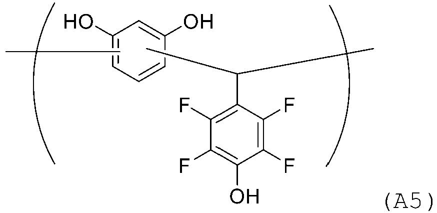

Under a nitrogen atmosphere, 22.0 g of the compound (a2), 34.9 g of the compound (b3), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A5). When the weight-average molecular weight (Mw) and dispersity (Mw/Mn) were measured by GPC, the results were as follows: Mw=2200, Mw/Mn=1.78.

### Synthesis Example 6

### Synthesis of Polymer (A6)

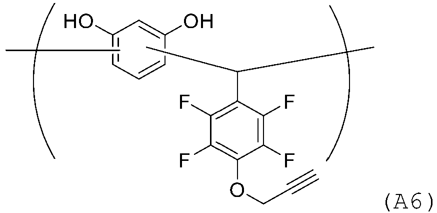

Under a nitrogen atmosphere, 22.0 g of the compound (a2), 41.8 g of the compound (b4), and 220 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A6). When the weight-average molecular weight (Mw) and dispersity (Mw/Mn) were measured by GPC, the results were as follows: Mw=2300, Mw/Mn=1.82.

### Synthesis Example 7

### Synthesis of Polymer (A7)

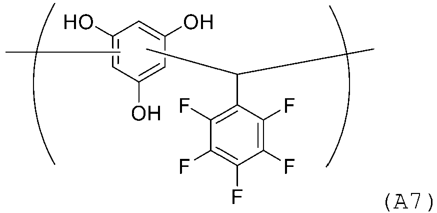

Under a nitrogen atmosphere, 25.2 g of the compound (a3), 39.2 g of the compound (b2), and 220 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A7). When the weight-average molecular weight (Mw) and dispersity (Mw/Mn) were measured by GPC, the results were as follows: Mw=2200, Mw/Mn=1.75.

### Synthesis Example 8

### Synthesis of Polymer (A8)

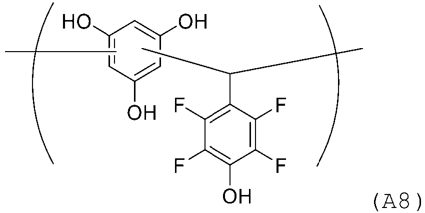

Under a nitrogen atmosphere, 25.2 g of the compound (a3), 38.8 g of the compound (b3), and 220 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A8). When the weight-average molecular weight (Mw) and dispersity (Mw/Mn) were measured by GPC, the results were as follows: Mw=2200, Mw/Mn=1.71.

### Synthesis Example 9

### Synthesis of Polymer (A9)

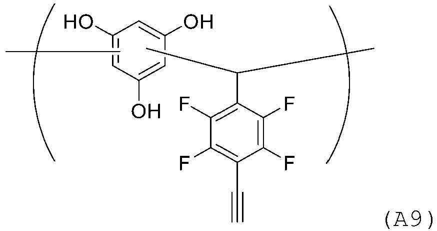

Under a nitrogen atmosphere, 25.2 g of the compound (a3), 40.4 g of the compound (b6), and 220 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A9). When the weight-average molecular weight (Mw) and dispersity (Mw/Mn) were measured by GPC, the results were as follows: Mw=2400, Mw/Mn=1.83.

### Synthesis Example 10

### Synthesis of Polymer (A10)

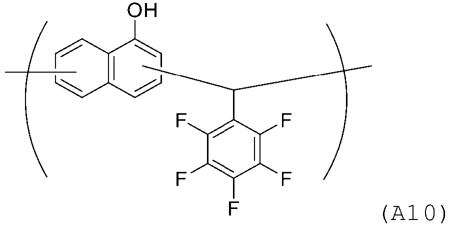

Under a nitrogen atmosphere, 28.8 g of the compound (a4), 35.3 g of the compound (b2), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A10). When the weight-average molecular weight (Mw) and dispersity (Mw/Mn) were measured by GPC, the results were as follows: Mw=3100, Mw/Mn=2.03.

### Synthesis Example 11

### Synthesis of Polymer (A11)

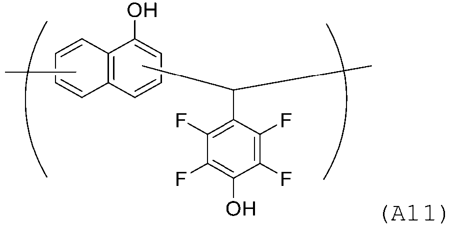

Under a nitrogen atmosphere, 28.8 g of the compound (a4), 34.9 g of the compound (b3), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A11). When the weight-average molecular weight (Mw) and dispersity (Mw/Mn) were measured by GPC, the results were as follows: Mw=3000, Mw/Mn=2.11.

### Synthesis Example 12

### Synthesis of Polymer (A12)

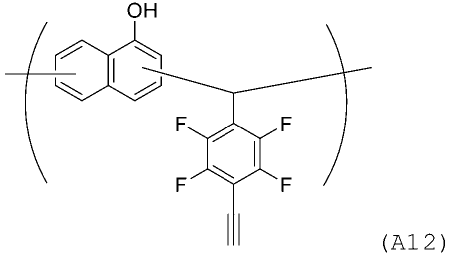

Under a nitrogen atmosphere, 28.8 g of the compound (a4), 36.4 g of the compound (b6), and 200 g of PGME were mixed together to form a homogeneous solution at a solution temperature of 100°C. After that, 4.0 g of a 25% aqueous solution of sodium hydroxide was slowly added to the homogeneous solution, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed twice with 50 g of a 3% aqueous solution of nitric acid and further washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A12). When the weight-average molecular weight (Mw) and dispersity (Mw/Mn) were measured by GPC, the results were as follows: Mw=2700, Mw/Mn=1.76.

### Synthesis Example 13

### Synthesis of Polymer (A13)

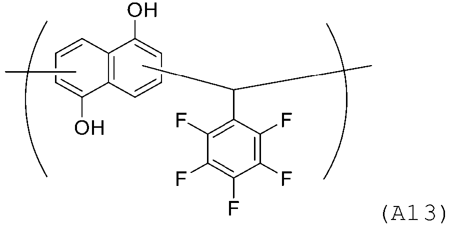

Under a nitrogen atmosphere, 32.0 g of the compound (a5), 33.3 g of the compound (b2), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A13). When the weight-average molecular weight (Mw) and dispersity (Mw/Mn) were measured by GPC, the results were as follows: Mw=3200, Mw/Mn=2.24.

### Synthesis Example 14

### Synthesis of Polymer (A14)

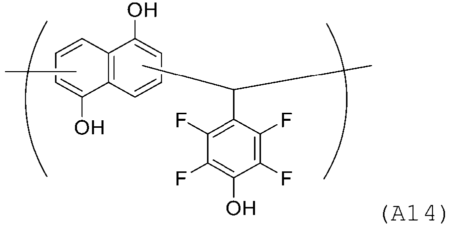

Under a nitrogen atmosphere, 32.0 g of the compound (a5), 33.0 g of the compound (b3), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A14). When the weight-average molecular weight (Mw) and dispersity (Mw/Mn) were measured by GPC, the results were as follows: Mw=2300, Mw/Mn=1.90.

### Synthesis Example 15

### Synthesis of Polymer (A15)

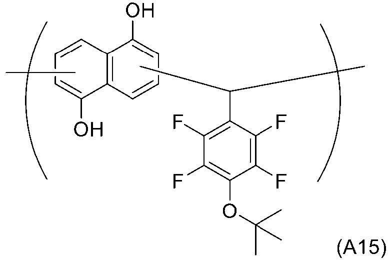

Under a nitrogen atmosphere, 32.0 g of the compound (a5), 43.0 g of the compound (b5), and 200 g of PGME were mixed together to form a homogeneous solution at a solution temperature of 100°C. After that, 4.0 g of a 25% aqueous solution of sodium hydroxide was slowly added to the homogeneous solution, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed twice with 50 g of a 3% aqueous solution of nitric acid and then further washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A15). When the weight-average molecular weight (Mw) and dispersity (Mw/Mn) were measured by GPC, the results were as follows: Mw=2400, Mw/Mn=1.67.

### Synthesis Example 16

### Synthesis of Polymer (A16)

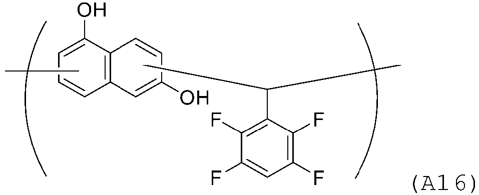

Under a nitrogen atmosphere, 32.0 g of the compound (a6), 32.1 g of the compound (b1), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A16). When the weight-average molecular weight (Mw) and dispersity (Mw/Mn) were measured by GPC, the results were as follows: Mw=3400, Mw/Mn=2.35.

### Synthesis Example 17

### Synthesis of Polymer (A17)

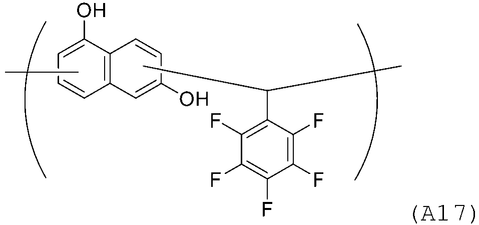

Under a nitrogen atmosphere, 32.0 g of the compound (a6), 35.3 g of the compound (b2), and 200 g of PGME were mixed together to form a homogeneous solution at a solution temperature of 100°C. After that, to the homogeneous solution, 20 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the obtained residue, 250 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A17). When the weight-average molecular weight (Mw) and dispersity (Mw/Mn) were measured by GPC, the results were as follows: Mw=3900, Mw/Mn=2.22.

### Synthesis Example 18

### Synthesis of Polymer (A18)

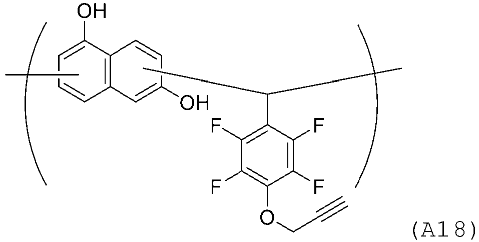

Under a nitrogen atmosphere, 32.0 g of the compound (a6), 41.8 g of the compound (b4), and 220 g of PGME were mixed together to form a homogeneous solution at a solution temperature of 100°C. After that, 4.0 g of a 25% aqueous solution of sodium hydroxide was slowly added to the homogeneous solution, and the mixture was stirred for 24 hours at a solution temperature of 110°C. The mixture was cooled to room temperature, and then 400 g of diisopropyl ether was added thereto to precipitate a polymer. The resultant was left to stand, and then the supernatant was removed by decantation. To the residue, 250 g of methyl isobutyl ketone was added to form a homogeneous solution. The homogeneous solution was transferred to a separating funnel, and the organic layer was washed twice with 50 g of a 3% aqueous solution of nitric acid and then further washed five times with 50 g of pure water. The organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A18). When the weight-average molecular weight (Mw) and dispersity (Mw/Mn) were measured by GPC, the results were as follows: Mw=2900, Mw/Mn=2.17.

### Synthesis Example 19

### Synthesis of Polymer (A19)

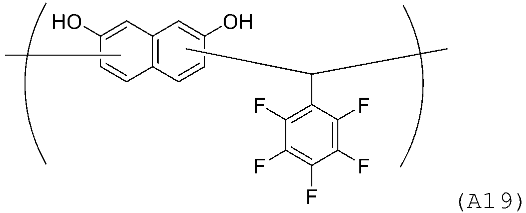

Under a nitrogen atmosphere, 32.0 g of the compound (a7), 19.2 g of methanesulfonic acid, and 100 g of 1,2-dichloroethane were mixed together to form a homogeneous solution at a solution temperature of 70°C. After that, 39.2 g of the compound (b2) was slowly added to the homogeneous solution, and the mixture was stirred for 8 hours at a solution temperature of 80°C. The mixture was cooled to room temperature, and then 200 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A19). When the weight-average molecular weight (Mw) and dispersity (Mw/Mn) were measured by GPC, the results were as follows: Mw=2800, Mw/Mn=2.12.

### Synthesis Example 20

### Synthesis of Polymer (A20)

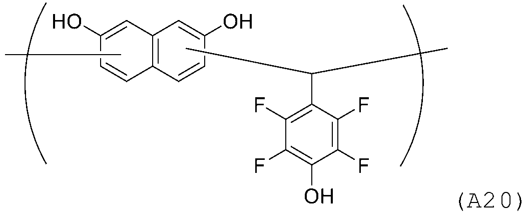

Under a nitrogen atmosphere, 32.0 g of the compound (a7), 19.2 g of methanesulfonic acid, and 100 g of 1,2-dichloroethane were mixed together to form a homogeneous solution at a solution temperature of 70°C. After that, a solution prepared beforehand by dissolving 38.8 g of the compound (b3) in 80 g of 1,2-dichloroethane was slowly added to the homogeneous solution, and the mixture was stirred for 8 hours at a solution temperature of 80°C. The mixture was cooled to room temperature, and then 200 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A20). When the weight-average molecular weight (Mw) and dispersity (Mw/Mn) were measured by GPC, the results were as follows: Mw=3100, Mw/Mn=2.32.

### Synthesis Example 21

### Synthesis of Polymer (A21)

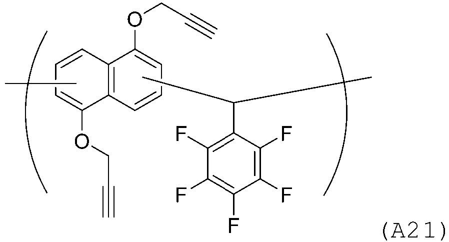

Under a nitrogen atmosphere, 35.4 g of the compound (a8), 14.4 g of methanesulfonic acid, and 100 g of 1,2-dichloroethane were mixed together to form a homogeneous solution at a solution temperature of 70°C. After that, 26.5 g of the compound (b2) was slowly added to the homogeneous solution, and the mixture was stirred for 8 hours at a solution temperature of 80°C. The mixture was cooled to room temperature, and then 200 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of hexane. The precipitated polymer was separated by filtration and dried under reduced pressure to obtain a polymer (A21). When the weight-average molecular weight (Mw) and dispersity (Mw/Mn) were measured by GPC, the results were as follows: Mw=2400, Mw/Mn=1.92.

### Synthesis Example 22

### Synthesis of Polymer (A22)

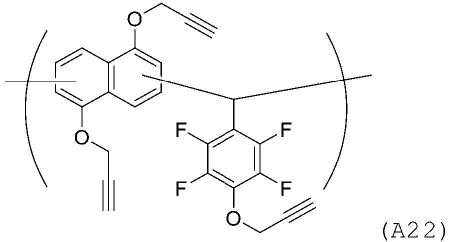

Under a nitrogen atmosphere, 35.4 g of the compound (a8), 14.4 g of methanesulfonic acid, and 100 g of 1,2-dichloroethane were mixed together to form a homogeneous solution at a solution temperature of 70°C. After that, 31.3 g of the compound (b4) was slowly added to the homogeneous solution, and the mixture was stirred for 8 hours at a solution temperature of 80°C. The mixture was cooled to room temperature, and then 200 g of diisopropyl ether was added thereto to precipitate a polymer. The resultant was left to stand, and then the supernatant was removed by decantation. To the obtained residue, 300 g of methyl isobutyl ketone was added to form a homogeneous solution. The homogeneous solution was transferred to a separating funnel, and the organic layer was washed five times with 50 g of pure water. After that, the organic layer was evaporated under reduced pressure to dryness. To the residue, 100 ml of THF was added, and a polymer was reprecipitated in 1000 ml of methanol. The precipitated polymer was separated by filtration and dried under reduced pressure to obtain a polymer (A22). When the weight-average molecular weight (Mw) and dispersity (Mw/Mn) were measured by GPC, the results were as follows: Mw=3200, Mw/Mn=1.54.

### Synthesis Example 23

### Synthesis of Polymer (A23)

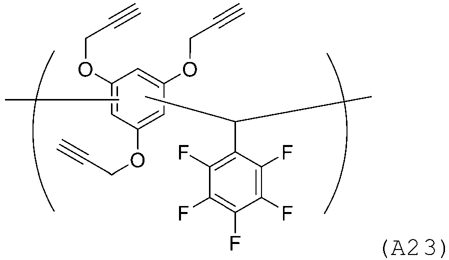

Under a nitrogen atmosphere, 20.0 g of the polymer (A7), 32.0 g of potassium carbonate, and 150 g of DMF were mixed together to form a homogeneous dispersion at an inner temperature of 50°C. To the homogeneous dispersion, 27.4 g of propargyl bromide was slowly added, and a reaction was carried out for 24 hours at an inner temperature of 50°C. To the reaction solution, 300 ml of methyl isobutyl ketone and 300 g of pure water were added to dissolve the precipitated salt. After that, the separated aqueous layer was removed. Furthermore, the organic layer was washed twice with 100 g of a 3% aqueous solution of nitric acid and six times with 100 g of pure water. After that, the organic layer was evaporated under reduced pressure to dryness to obtain a resin (polymer) (A23). When the weight-average molecular weight (Mw) and dispersity (Mw/Mn) were measured by GPC, the results were as follows: Mw=3000, Mw/Mn=1.81.

### Synthesis Example 24

### Synthesis of Polymer (A24)

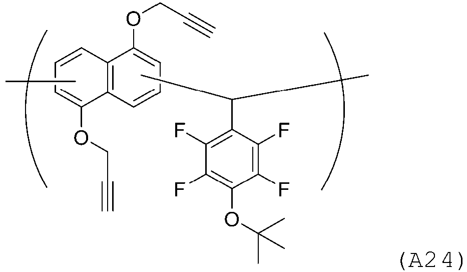

Under a nitrogen atmosphere, 20.0 g of the polymer (A15), 15.5 g of potassium carbonate, and 100 g of DMF were mixed together to form a homogeneous dispersion at an inner temperature of 50°C. To the homogeneous dispersion, 15.2 g of propargyl bromide was slowly added, and a reaction was carried out for 24 hours at an inner temperature of 50°C. To the reaction solution, 300 ml of methyl isobutyl ketone and 300 g of pure water were added to dissolve the precipitated salt. After that, the separated aqueous layer was removed. Furthermore, the organic layer was washed twice with 100 g of a 3% aqueous solution of nitric acid and six times with 100 g of pure water. After that, the organic layer was evaporated under reduced pressure to dryness to obtain a resin (polymer) (A24). When the weight-average molecular weight (Mw) and dispersity (Mw/Mn) were measured by GPC, the results were as follows: Mw=2900, Mw/Mn=1.70.

### Synthesis Example 25

### Synthesis of Polymer (A25)

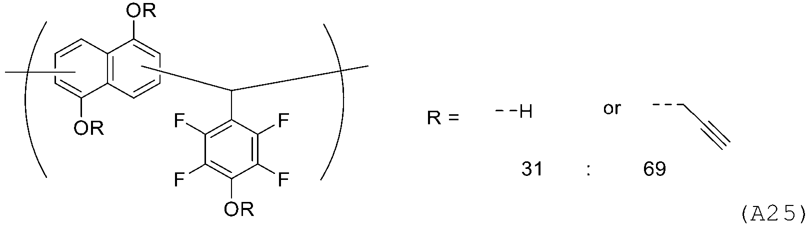

Under a nitrogen atmosphere, 20.0 g of the polymer (A14), 27.1 g of potassium carbonate, and 100 g of DMF were mixed together to form a homogeneous dispersion at an inner temperature of 50°C. To the homogeneous dispersion, 14.9 g of propargyl bromide was slowly added, and a reaction was carried out for 24 hours at an inner temperature of 50°C. To the reaction solution, 300 ml of methyl isobutyl ketone and 300 g of pure water were added to dissolve the precipitated salt. After that, the separated aqueous layer was removed. Furthermore, the organic layer was washed twice with 100 g of a 3% aqueous solution of nitric acid and six times with 100 g of pure water. After that, the organic layer was evaporated under reduced pressure to dryness to obtain a resin (polymer) (A25). When the weight-average molecular weight (Mw) and dispersity (Mw/Mn) were measured by GPC, the results were as follows: Mw=2900, Mw/Mn=2.08. Meanwhile, the reaction rate of hydroxy groups calculated by 1H NMR was 69%.

### Comparative Synthesis Examples: Synthesis of Polymers (R1) to (R4) for Comparative Examples

For the synthesis of polymers (R1) to (R4) for Comparative Examples, the comparative raw materials ((Ra1) to (Ra5)) shown below and the aromatic compounds (a5) and (a6) were used. Note that the comparative raw material (Ra5) was used for the reaction as a 37% aqueous solution.

### Comparative raw materials:

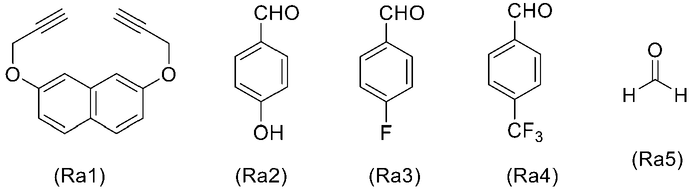

### Comparative Synthesis Example 1

### Synthesis of Comparative Polymer (R1)

Under a nitrogen atmosphere, 80.1 g of the compound (a5), 48.8 g of the compound (Ra2), and 250 g of PGME were mixed together to form a homogeneous solution at a solution temperature of 100°C. After that, to the homogeneous solution, 30 g of a 20 wt% solution of p-toluenesulfonic acid monohydrate in PGME formed into a homogeneous solution beforehand was slowly added, and the mixture was stirred for 24 hours at a solution temperature of 110°C. The mixture was cooled to room temperature, and then 600 g of diisopropyl ether was added thereto to precipitate a polymer. The resultant was left to stand, and then the supernatant was removed by decantation. To the obtained residue, 500 g of methyl isobutyl ketone was added to form a homogeneous solution. The homogeneous solution was transferred to a separating funnel, and the organic layer was washed five times with 200 g of pure water. After that, the organic layer was evaporated under reduced pressure to dryness. To the residue, 300 ml of THF was added, and a polymer was reprecipitated in 2000 ml of hexane. The precipitated polymer was separated by filtration and dried under reduced pressure to obtain a comparative polymer (R1). When the weight-average molecular weight (Mw) and dispersity (Mw/Mn) were measured by GPC, the results were as follows: Mw=3200, Mw/Mn=2.07.

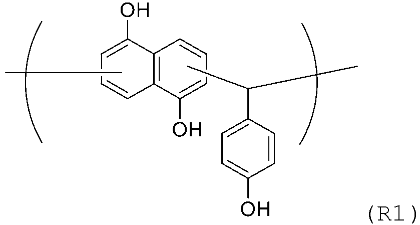

### Comparative Synthesis Example 2

### Synthesis of Comparative Polymer (R2)

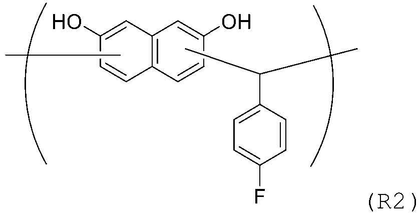

Under a nitrogen atmosphere, 160.2 g of the compound (a7), 124.1 g of the compound (Ra3), and 400g of 1-butanol were mixed together to form a homogeneous solution at a solution temperature of 50°C. After that, 16.0 g of concentrated sulfuric acid was slowly added to the homogeneous solution, the inner temperature was raised to 110°C, and the mixture was stirred for 8 hours. The mixture was cooled to room temperature, and then 800 ml of methyl isobutyl ketone and 300 g of pure water were added thereto to form a homogeneous solution. After that, the separated aqueous layer was removed. Furthermore, the organic layer was washed twice with 100 g of a 3% aqueous solution of nitric acid and six times with 100 g of pure water. After that, the organic layer was evaporated under reduced pressure to dryness to obtain a comparative polymer (R2). When the weight-average molecular weight (Mw) and dispersity (Mw/Mn) were measured by GPC, the results were as follows: Mw=880, Mw/Mn=1.27.

### Comparative Synthesis Example 3

### Synthesis of Comparative Polymer (R3)

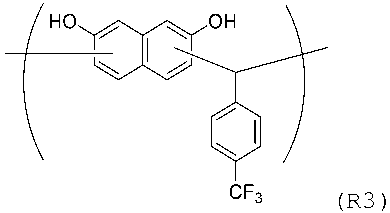

Under a nitrogen atmosphere, 160.2 g of the compound (a7), 174.1 g of the compound (Ra4), and 400 g of 1-butanol were mixed together to form a homogeneous solution at a solution temperature of 50°C. After that, 16.0 g of concentrated sulfuric acid was slowly added to the homogeneous solution, the inner temperature was raised to 110°C, and the mixture was stirred for 8 hours. The mixture was cooled to room temperature, and then 800 ml of methyl isobutyl ketone and 300 g of pure water were added thereto to form a homogeneous solution. After that, the separated aqueous layer was removed. Furthermore, the organic layer was washed twice with 100 g of a 3% aqueous solution of nitric acid and six times with 100 g of pure water. After that, the organic layer was evaporated under reduced pressure to dryness to obtain a comparative polymer (R3). When the weight-average molecular weight (Mw) and dispersity (Mw/Mn) were measured by GPC, the results were as follows: Mw=950, Mw/Mn=1.32.

### Comparative Synthesis Example 4

### Synthesis of Comparative Polymer (R4)

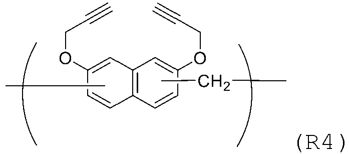

Under a nitrogen atmosphere, 80.1 g of the compound (Ra1), 28.4 g of (Ra5), and 400 g of 1,2-dichloroethane were mixed together to form a homogeneous solution at a solution temperature of 70°C. After that, 5 g of methanesulfonic acid was added slowly to the homogeneous solution, and the mixture was stirred for 8 hours at a solution temperature of 80°C. The mixture was cooled to room temperature, then 500 g of methyl isobutyl ketone was added thereto, and the organic layer was washed five times with 200 g of pure water. After that, the organic layer was evaporated under reduced pressure to dryness. To the residue, 300 ml of THF was added, and a polymer was reprecipitated in 2,000 ml of hexane. The precipitated polymer was separated by filtration and dried under reduced pressure to obtain a compound (comparative polymer) (R4). When the weight-average molecular weight (Mw) and dispersity (Mw/Mn) were measured by GPC, the results were as follows: Mw=2800, Mw/Mn=1.57.

A list of the measurement results of the Mw and Mw/Mn of the polymers (A1) to (A25) used in Examples and the comparative polymers (R1) to (R4) used in Comparative Examples is shown in Tables 1 to 4.

**[Table 1]**

| Synthesis Example | Polymer | Mw | Mw /Mn |
|---|---|---|---|
| 1 | 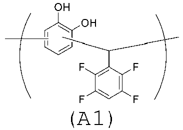 | 3700 | 2.17 |
| 2 | 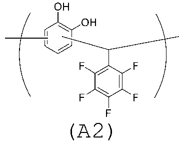 | 3500 | 2.24 |
| 3 | 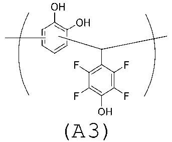 | 2900 | 2.01 |
| 4 | 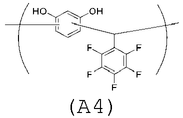 | 2100 | 1. 88 |
| 5 | 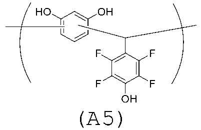 | 2200 | 1. 78 |
| 6 | 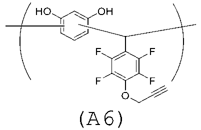 | 2300 | 1.82 |
| 7 | 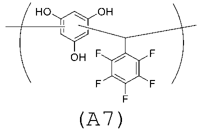 | 2200 | 1.75 |
| 8 | 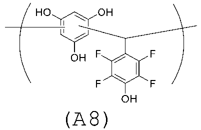 | 2200 | 1.71 |
| 9 | 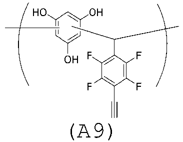 | 2400 | 1.83 |

**[Table 2]**

| Synthesis Example | Polymer | Mw | Mw /Mn |
|---|---|---|---|
| 10 | 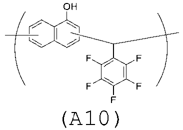 | 3100 | 2.03 |
| 11 | 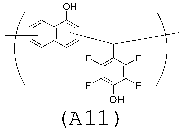 | 3000 | 2.11 |
| 12 | 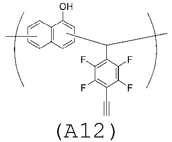 | 2700 | 1. 76 |
| 13 | 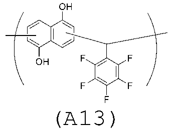 | 3200 | 2.24 |
| 14 | 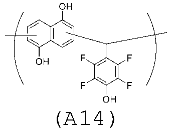 | 2300 | 1.90 |
| 15 | 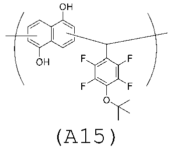 | 2400 | 1.67 |
| 16 | 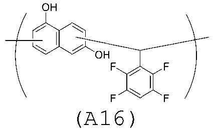 | 3400 | 2.35 |
| 17 | 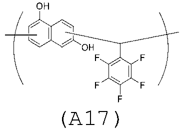 | 3900 | 2.22 |
| 18 | 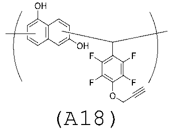 | 2900 | 2.17 |

**[Table 3]**

| Synthesis Example | Polymer | Mw | Mw /Mn |
|---|---|---|---|
| 19 | 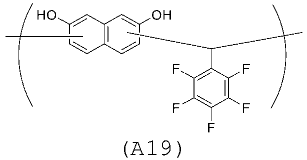 | 2800 | 2.12 |
| 20 | 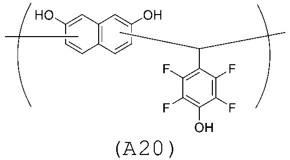 | 3100 | 2.32 |
| 21 | 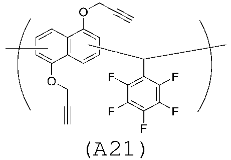 | 2400 | 1.92 |
| 22 | 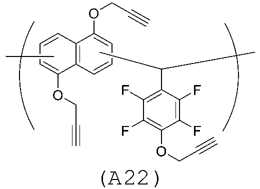 | 3200 | 1. 54 |
| 23 | 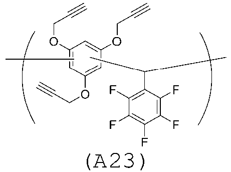 | 3000 | 1.81 |
| 24 | 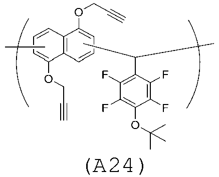 | 2900 | 1. 70 |
| 25 | 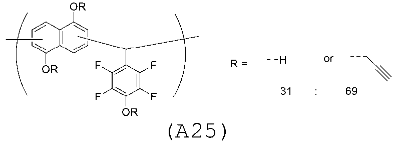 | 2900 | 2.08 |

**[Table 4]**

| Comparative Synthesis Example | Comparative polymer | Mw | Mw /Mn |
|---|---|---|---|
| 1 | 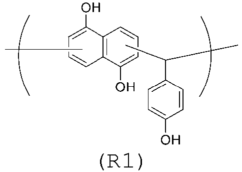 | 3200 | 2.07 |
| 2 | 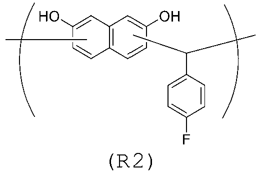 | 880 | 1.27 |
| 3 | 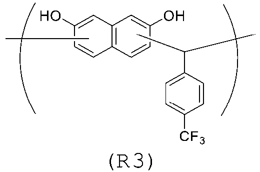 | 950 | 1.32 |
| 4 | 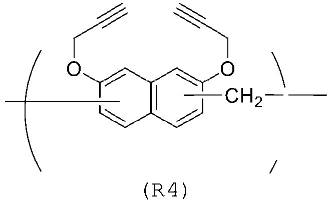 | 2800 | 1. 57 |

### Preparation of Compositions (UDL-1 to -29, Comparative UDL-1 to -5) for Forming Organic Film

One of the polymers (A1) to (A25) and comparative polymers (R1) to (R4) synthesized as described above was dissolved using propylene glycol monomethyl ether acetate (PGMEA) containing 0.1 mass% of FC-4430 (manufactured by Sumitomo 3M Ltd.) according to the proportions shown in Table 5, and the mixture was filtered through a 0.1-µm filter made of a fluorinated resin. Thus, compositions (UDL-1 to -29, comparative UDL-1 to -5) for forming an organic film were prepared. Note that, for the preparation of UDL-29 and comparative UDL-5, an acid generator (AG) and a crosslinking agent (XL) were used. Meanwhile, for the preparation of UDL-26 to -28, (S1) 1,6-diacetoxyhexane, having a boiling point of 260°C, and/or (S2) tripropylene glycol monomethyl ether, having a boiling point of 242°C was used as a high-boiling-point solvent.

**[Table 5]**

| Composition for forming organic film | Polymer (parts by mass) | Crosslinking agent (parts by mass) | Thermal acid generator (parts by mass) | High-boiling-point solvent (parts by mass) | PGMEA (parts by mass) |
|---|---|---|---|---|---|
| UDL-1 | A1(10) | - | - | - | 90 |
| UDL-2 | A2(10) | - | - | - | 90 |
| UDL-3 | A3 (10) | - | - | - | 90 |
| UDL-4 | A4 (10) | - | - | - | 90 |
| UDL-5 | A5(10) | - | - | - | 90 |
| UDL- 6 | A6 (10) | - | - | - | 90 |
| UDL-7 | A7 (10) | - | - | - | 90 |
| UDL-8 | A8 (10) | - | - | - | 90 |
| UDL-9 | A9 (10) | - | - | - | 90 |
| UDL-10 | A10 (10) | - | - | - | 90 |
| UDL-11 | A11 (10) | - | - | - | 90 |
| UDL-12 | A12 (10) | - | - | - | 90 |
| UDL-13 | A13 (10) | - | - | - | 90 |
| UDL-14 | A14 (10) | - | - | - | 90 |
| UDL-15 | A15 (10) | - | - | - | 90 |
| UDL-16 | A16 (10) | - | - | - | 90 |
| UDL-17 | A17 (10) | - | - | - | 90 |
| UDL-18 | A18 (10) | - | - | - | 90 |
| UDL-19 | A19 (10) | - | - | - | 90 |
| UDL-20 | A20 (10) | - | - | - | 90 |
| UDL-21 | A21 (10) | - | - | - | 90 |
| UDL-22 | A22 (10) | - | - | - | 90 |
| UDL-23 | A23 (10) | - | - | - | 90 |
| UDL-24 | A24 (10) | - | - | - | 90 |
| UDL-25 | A25 (10) | - | - | - | 90 |
| UDL-2 6 | A8 (10) | - | - | S1 (10) | 80 |
| UDL-27 | A14 (10) | - | - | S2 (10) | 80 |
| UDL-28 | A23 (10) | - | - | S1(5)S2(5) | 80 |
| UDL-29 | A19 (10) | XL (1) | AG(0.1) | - | 80 |
| Comparative UDL-1 | R1 (10) | - | - | - | 90 |
| Comparative UDL-2 | R2 (10) | - | - | - | 90 |
| Comparative UDL-3 | R3 (10) | - | - | - | 90 |
| Comparative UDL-4 | R4 (10) | - | - | - | 90 |
| Comparative UDL-5 | R2 (10) | XL (1) | AG(0.1) | - | 90 |

The structural formulae of the acid generator (AG) and the crosslinking agent (XL) used in the preparation of UDL-29 and comparative UDL-5 are shown below.

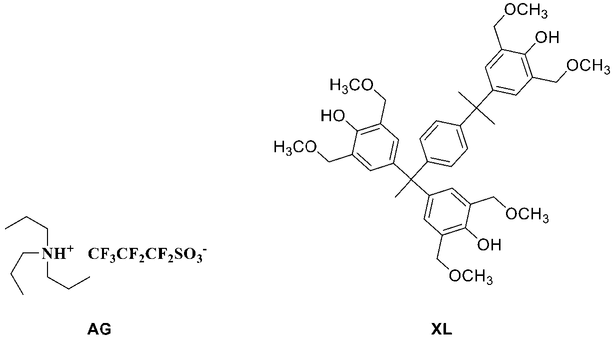

### Example 1: Solvent Resistance Measurement (Examples 1-1 to 1-29, Comparative Examples 1-1 to 1-5)

Each of UDL-1 to -29 and comparative UDL-1 to -5 prepared above was respectively applied onto a silicon substrate, and each coating film was baked in the atmosphere at 350°C or 250°C for 60 seconds to form each organic film. After that, the film thickness of each organic film (film thickness after film formation) "a" [Å] was measured. Subsequently, a PGMEA solvent was dispensed on each organic film and allowed to stand for 30 seconds. Subsequently, the resultant was spin-dried and baked at 100°C for 60 seconds to evaporate the PGMEA. After that, the film thickness of each organic film (film thickness after PGMEA treatment) "b" [Å] was measured. The film remaining percentage [%] (=(b/a)×100) was calculated from the film thickness "a" after film formation and the film thickness "b" after PGMEA treatment. The results are shown in Table 6.

**[Table 6]**

| | Composition for forming organic film | Film thickness after film formation: a (Å) | Film thickness after PGMEA treatment: b (Å) | Film remaining percentage (b/a) × 100 (%) | Baking conditions (temperature × time) |
|---|---|---|---|---|---|
| Example 1-1 | UDL-1 | 2006 | 2005 | 100.0 | 350°C×60 seconds |
| Example 1-2 | UDL-2 | 2013 | 2011 | 99.9 | 350°C×60 seconds |
| Example 1-3 | UDL-3 | 1995 | 1994 | 99.9 | 350°C×60 seconds |
| Example 1-4 | UDL-4 | 1993 | 1992 | 99.9 | 350°C×60 seconds |
| Example 1-5 | UDL-5 | 1999 | 1999 | 100.0 | 350°C×60 seconds |
| Example 1-6 | UDL-6 | 2007 | 2003 | 99.8 | 350°C×60 seconds |
| Example 1-7 | UDL-7 | 2015 | 2013 | 99.9 | 350°C×60 seconds |
| Example 1-8 | UDL-8 | 2010 | 2010 | 100.0 | 350°C×60 seconds |
| Example 1-9 | UDL-9 | 2012 | 2011 | 100.0 | 350°C×60 seconds |
| Example 1-10 | UDL-10 | 1999 | 1998 | 99.9 | 350°C×60 seconds |
| Example 1-11 | UDL-11 | 2007 | 2006 | 100.0 | 350°C×60 seconds |
| Example 1-12 | UDL-12 | 2005 | 2005 | 100.0 | 350°C×60 seconds |
| Example 1-13 | UDL-13 | 1999 | 1999 | 100.0 | 350°C×60 seconds |
| Example 1-14 | UDL-14 | 2003 | 2003 | 100.0 | 350°C×60 seconds |
| Example 1-15 | UDL-15 | 1993 | 1990 | 99.8 | 350°C×60 seconds |
| Example 1-16 | UDL-16 | 2005 | 2004 | 100.0 | 350°C×60 seconds |
| Example 1-17 | UDL-17 | 1991 | 1990 | 99.9 | 350°C×60 seconds |
| Example 1-18 | UDL-18 | 1993 | 1991 | 99.9 | 350°C×60 seconds |
| Example 1-19 | UDL-19 | 1991 | 1991 | 100.0 | 350°C×60 seconds |
| Example 1-20 | UDL-20 | 1996 | 1994 | 99.9 | 350°C×60 seconds |
| Example 1-21 | UDL-21 | 1994 | 1994 | 100.0 | 350°C×60 seconds |
| Example 1-22 | UDL-22 | 2012 | 2011 | 100.0 | 250°C×60 seconds |
| Example 1-23 | UDL-23 | 1995 | 1994 | 99.9 | 250°C×60 seconds |
| Example 1-24 | UDL-24 | 2006 | 2005 | 100.0 | 350°C×60 seconds |
| Example 1-25 | UDL-25 | 1999 | 1998 | 99.9 | 350°C×60 seconds |
| Example 1-26 | UDL-26 | 2006 | 2006 | 100.0 | 350°C×60 seconds |
| Example 1-27 | UDL-27 | 2013 | 2011 | 99.9 | 350°C×60 seconds |
| Example 1-28 | UDL-28 | 1990 | 1990 | 100.0 | 350°C×60 seconds |
| Example 1-29 | UDL-29 | 2010 | 2008 | 99.9 | 250°C×60 seconds |
| Comparative Example 1-1 | Comparative UDL-1 | 2000 | 1997 | 99.9 | 350°C×60 seconds |
| Comparative Example 1-2 | Comparative UDL-2 | 1992 | 1278 | 64.2 | 350°C×60 seconds |
| Comparative Example 1-3 | Comparative UDL-3 | 2003 | 1289 | 64.4 | 350°C×60 seconds |
| Comparative Example 1-4 | Comparative UDL-4 | 2015 | 2011 | 99.8 | 250°C×60 seconds |
| Comparative Example 1-5 | Comparative UDL-5 | 2015 | 2010 | 99.8 | 350°C×60 seconds |

As shown in Table 6, the organic films (Examples 1-1 to 1-29) formed using the inventive compositions for forming an organic film UDL-1 to -29 had a film remaining percentage after the PGMEA treatment of more than 99.5%, and it can be observed that a crosslinking reaction occurred by virtue of the heat treatment, and sufficient solvent resistance was exhibited. In contrast, in Comparative Examples 1-2 and 1-3, where comparative polymers (R2) and (R3) were used, there were few moieties per molecule of the polymer to contribute to the crosslinking reaction due to low molecular weight, and therefore, it was not possible to ensure sufficient solvent resistance even though a baking treatment at 350°C was carried out. Therefore, the comparative polymer (R2), having a low molecular weight, required the addition of an acid generator and a crosslinking agent to exhibit solvent resistance as in Comparative Example 1-5. Meanwhile, regarding compositions UDL-22 and -23 for forming an organic film, containing polymers (A22) and (A23), each having a particular substituent introduced into the substituent structure on an aromatic ring, sufficient film remaining percentage was successfully ensured even with baking at 250°C as clearly shown by the results of Examples 1-22 and 1-23, and by virtue of appropriately selecting the substituents of the polymer, it was possible appropriately to adjust the range of the baking temperature to be applied to achieve curability.

### [In-Plane Uniformity Evaluation: Examples 2-1 to 2-29, Comparative Example 1-1 to 1-5]

Each organic film was formed on a 300-mm silicon substrate by the same method as that performed in Example 1 by using each of the compositions (UDL-1 to - 29, comparative UDL-1 to -5) for forming an organic film under the same baking conditions and film thickness conditions as in Example 1. In this event, the film thickness was measured at the portions within a radius of 145 mm from the center of each organic film. The maximum value Xₘₐₓ of the film thickness, the minimum value Xₘᵢₙ of the film thickness, and the average film thickness X_{average} were obtained, and the value determined by (Xₘₐₓ-Xₘᵢₙ) /X_{average} was obtained as in-plane uniformity (%). When the in-plane uniformity was less than 2%, the evaluation A (good) was given, when 2% or more to less than 3%, B, and when 3% or more, C (poor), and in this manner, the in-plane film thickness uniformity of each organic film was evaluated. The results are shown below in Table 7.

**[Table 7]**

| | Composition for forming organic film | In-plane uniformity evaluation result | Baking conditions (temperature × time) |
|---|---|---|---|
| Example 2-1 | UDL-1 | A | 350°C×60 seconds |
| Example 2-2 | UDL-2 | A | 350°C×60 seconds |
| Example 2-3 | UDL-3 | A | 350°C×60 seconds |
| Example 2-4 | UDL-4 | A | 350°C×60 seconds |
| Example 2-5 | UDL-5 | A | 350°C×60 seconds |
| Example 2-6 | UDL-6 | A | 350°C×60 seconds |
| Example 2-7 | UDL-7 | A | 350°C×60 seconds |
| Example 2-8 | UDL-8 | A | 350°C×60 seconds |
| Example 2-9 | UDL-9 | A | 350°C×60 seconds |
| Example 2-10 | UDL-10 | A | 350°C×60 seconds |
| Example 2-11 | UDL-11 | A | 350°C×60 seconds |
| Example 2-12 | UDL-12 | A | 350°C×60 seconds |
| Example 2-13 | UDL-13 | A | 350°C×60 seconds |
| Example 2-14 | UDL-14 | A | 350°C×60 seconds |
| Example 2-15 | UDL-15 | A | 350°C×60 seconds |
| Example 2-16 | UDL-16 | A | 350°C×60 seconds |
| Example 2-17 | UDL-17 | A | 350°C×60 seconds |
| Example 2-18 | UDL-18 | A | 350°C×60 seconds |
| Example 2-19 | UDL-19 | A | 350°C×60 seconds |
| Example 2-20 | UDL-20 | A | 350°C×60 seconds |
| Example 2-21 | UDL-21 | A | 350°C×60 seconds |
| Example 2-22 | UDL-22 | A | 250°C×60 seconds |
| Example 2-23 | UDL-23 | A | 250°C×60 seconds |
| Example 2-24 | UDL-24 | A | 350°C×60 seconds |
| Example 2-25 | UDL-25 | A | 350°C×60 seconds |
| Example 2-26 | UDL-26 | A | 350°C×60 seconds |
| Example 2-27 | UDL-27 | A | 350°C×60 seconds |
| Example 2-28 | UDL-28 | A | 350°C×60 seconds |
| Example 2-29 | UDL-29 | A | 250°C×60 seconds |
| Comparative Example 2-1 | Comparative UDL-1 | A | 350°C×60 seconds |
| Comparative Example 2-2 | Comparative UDL-2 | C | 350°C×60 seconds |
| Comparative Example 2-3 | Comparative UDL-3 | C | 350°C×60 seconds |
| Comparative Example 2-4 | Comparative UDL-4 | A | 250°C×60 seconds |
| Comparative Example 2-5 | Comparative UDL-5 | B | 350°C×60 seconds |

As shown in Table 7, it can be observed that the organic film (Example 2-1 to 2-29) formed using the inventive compositions UDL-1 to -29 for forming an organic film have excellent in-plane uniformity. This results from the fact that sublimation products at the time of baking are suppressed by the polymer having a favorable range of molecular weight and the fact that there is no degradation in film thickness caused by thermal decomposition or the like, since the polymer has sufficient thermosetting property, as also seen from the results of Example 1. In contrast, in Comparative Examples 2-2 and 2-3, where used were comparative polymers (R2) and (R3), which had not been able to achieve solvent resistance in Example 1, the molecular weight was low and curability was also insufficient, and therefore, it was not possible to form a film having a uniform film thickness. Meanwhile, even when an acid generator and a crosslinking agent were added to achieve solvent resistance as in Comparative Example 1-5, where comparative polymer (R2) was used, in-plane uniformity was improved, but it was not possible to achieve in-plane uniformity of less than 2%.

### Example 3: Hardness Measurement (Examples 3-1 to 3-29, Comparative Examples 3-1 to 3-5)

Each of UDL-1 to -29 and comparative UDL-1 to -5 prepared above was respectively applied onto a silicon substrate, and the coating film was baked in the atmosphere at 350°C or 250°C for 60 seconds to form a 200-nm thick organic film. These films were subjected to a nanoindentation test by using a TriboIndenter TI 950 model apparatus manufactured by Hysitron, Inc. to measure the hardness of each organic film. The results are shown in Table 8.

**[Table 8]**

| | Composition for forming organic film | Hardness (GPa) |
|---|---|---|
| Example 3-1 | UDL-1 | 0.82 |
| Example 3-2 | UDL-2 | 0.84 |
| Example 3-3 | UDL-3 | 0.93 |
| Example 3-4 | UDL-4 | 0.81 |
| Example 3-5 | UDL-5 | 0. 95 |
| Example 3-6 | UDL-6 | 0.85 |
| Example 3-7 | UDL-7 | 0. 87 |
| Example 3-8 | UDL-8 | 0. 97 |
| Example 3-9 | UDL-9 | 0.93 |
| Example 3-10 | UDL-10 | 0.71 |
| Example 3-11 | UDL-11 | 0.78 |
| Example 3-12 | UDL-12 | 0.77 |
| Example 3-13 | UDL-13 | 0.86 |
| Example 3-14 | UDL-14 | 0. 97 |
| Example 3-15 | UDL-15 | 0. 97 |
| Example 3-16 | UDL-16 | 0.82 |
| Example 3-17 | UDL-17 | 0.81 |
| Example 3-18 | UDL-18 | 0.84 |
| Example 3-19 | UDL-19 | 0.76 |
| Example 3-20 | UDL-20 | 0. 95 |
| Example 3-21 | UDL-21 | 0.81 |
| Example 3-22 | UDL-22 | 0.72 |
| Example 3-23 | UDL-23 | 0.71 |
| Example 3-24 | UDL-24 | 0.83 |
| Example 3-25 | UDL-25 | 0. 88 |
| Example 3-26 | UDL-27 | 0. 97 |
| Example 3-27 | UDL-28 | 0. 96 |
| Example 3-28 | UDL-29 | 0.82 |
| Example 3-29 | UDL-30 | 0.74 |
| Comparative Example 3-1 | Comparative UDL-1 | 0. 88 |
| Comparative Example 3-2 | Comparative UDL-2 | 0. 44 |
| Comparative Example 3-3 | Comparative UDL-3 | 0.46 |
| Comparative Example 3-4 | Comparative UDL-4 | 0.72 |
| Comparative Example 3-5 | Comparative UDL-5 | 0.54 |

As shown in Table 8, the organic films formed in Examples 3-1 to 3-29 had greater hardness than the organic films formed in Comparative Examples 3-2 and 3-3. From the above, it was confirmed that the polymers contained in the inventive compositions for forming an organic film were capable of being formed into a dense and strong film compared to comparative polymers (R2) and (R3), into which a fluorine structure was introduced. As can be seen from the results of Example 1 as well, these results reflect the fact that thermosetting property was sufficient. Regarding comparative UDL-5 of Comparative Example 3-5, solvent resistance was achieved by using a thermal acid generator and a crosslinking agent, but from the result of the hardness of the film the denseness of the film was poor.

### Example 4: Pattern Etching Test (Examples 4-1 to 4-29, Comparative Examples 4-1 to 4-3)

Each of UDL-1 to -29 and comparative UDL-1, -4, and -5 prepared above was respectively applied onto a Si wafer substrate having a diameter of 300 mm, on which a 200-nm thick SiO₂ film had been formed, and the coating film was baked in the atmosphere under the same baking conditions as in Example 3, so that each had a film thickness of 200 nm, to form each organic film (resist underlayer film). A silicon-containing resist middle layer film material (SOG-1) was applied onto each organic film, and the coating film was baked at 220°C for 60 seconds to form a 35-nm thick silicon-containing resist middle layer film. Subsequently, a resist upper layer film material (SL resist for ArF) was applied onto the silicon-containing resist middle layer film, and the coating film was baked at 105°C for 60 seconds to form a 100-nm thick resist upper layer film. Subsequently, a liquid immersion top coat composition (TC-1) was applied onto the resist upper layer film, and the coating film was baked at 90°C for 60 seconds to form a 50-nm thick top coat. Incidentally, regarding comparative UDL-2 and ULD-3, sufficient solvent resistance was not exhibited as shown by the results of Example 1, and therefore, it was not possible to proceed to the pattern etching test.

The resist upper layer film material (SL resist for ArF) was prepared by dissolving a polymer (RP1), an acid generator (PAG1), and a basic compound (Amine1), each in the proportion shown in Table 9, in a solvent containing 0.1 mass% of FC-430 (manufactured by Sumitomo 3M Limited), and filtering the mixture through a 0.1-µm filter made of a fluororesin.

**[Table 9]**

| | Polymer (parts by mass) | Acid generator (parts by mass) | Basic compound (parts by mass) | Solvent (parts by mass) |
|---|---|---|---|---|
| SL resist for ArF | RP1 (100) | PAG1 (6.6) | Amine1 (0.8) | PGMEA (2500) |

The structural formulae of the polymer (RP1), the acid generator (PAG1), and the basic compound (Amine1) used are shown below.

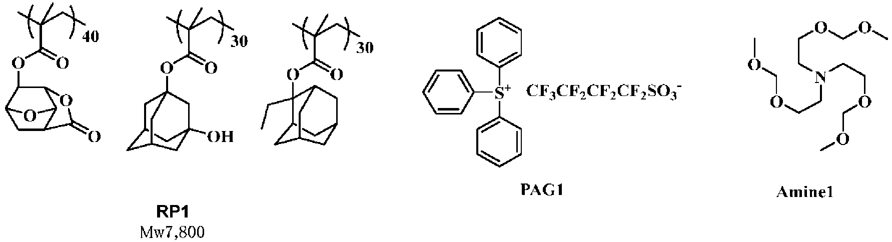

The liquid immersion top coat composition (TC-1) was prepared by dissolving a top coat polymer (PP1) in an organic solvent in the proportion shown in Table 10, and filtering the mixture through a 0.1-µm filter made of a fluororesin.

**[Table 10]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The structural formula of the polymer (PP1) used is shown below.

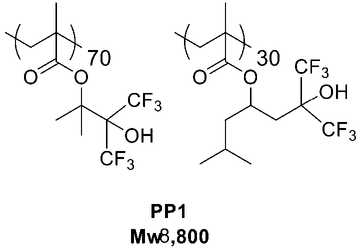

The silicon-containing resist middle layer film material (SOG-1) was prepared by dissolving a silicon-containing middle layer film polymer for ArF represented by (SiP1) and a crosslinking catalyst (CAT1) in an organic solvent containing 0.1 mass% of FC-4430 (manufactured by Sumitomo 3M Limited) in the proportions shown in Table 11, and filtering the mixture through a filter made of a fluororesin having a pore size of 0.1 µm.

**[Table 11]**

| | Polymer | Thermal crosslinking catalyst | Organic solvent |
|---|---|---|---|
| | (parts by mass) | (parts by mass) | (parts by mass) |
| SOG1 | SiP1 (100) | CAT1 (1) | Propylene glycol monoethyl ether (4000) |

The structural formulae of the silicon-containing middle layer film polymer (SiP1) for ArF and the crosslinking catalyst (CAT1) used are shown below.

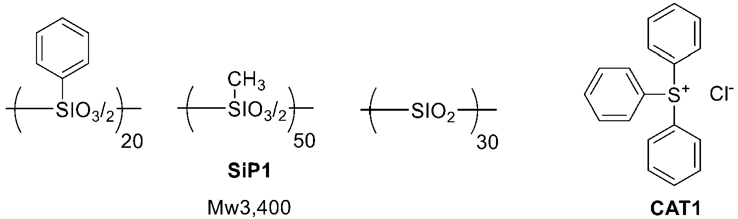

Then, the resist upper layer film was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask) while changing the exposure dose, baked at 100°C for 60 seconds (PEB), and developed with a 2.38% by mass aqueous solution of tetramethylammonium hydroxide (TMAH) for 30 seconds. Thus, positive line-and-space patterns (resist patterns) having a pitch of 100 nm and resist line widths of 50 nm to 30 nm were obtained.

Subsequently, using an etching apparatus Telius manufactured by Tokyo Electron Ltd., the silicon-containing resist middle layer film was processed by dry etching while using the resist pattern as a mask to obtain a silicon-containing resist middle layer film pattern. Subsequently, the organic film was processed by dry etching using the same apparatus while using the silicon-containing resist middle layer film pattern as a mask to obtain an organic film pattern. Subsequently, the SiO₂ film was processed by dry etching using the same apparatus while using the organic film pattern as a mask.

The etching conditions were as shown below.

Conditions in transferring resist pattern to SOG film.
Chamber pressure: 80 mT
RF-power (upper portion): 500 W
RF-power (lower portion): 300 W
CF₄ gas flow rate: 200 sccm
Time: 35 sec

Conditions in transferring SOG film pattern to organic film.
Chamber pressure: 10 mT
RF-power (upper portion): 1000 W
RF-power (lower portion): 300 W
CO₂ gas flow rate: 320 sccm
N₂ gas flow rate: 80 sccm
Time: 30 sec

Conditions in transferring organic film pattern to SiO₂ film.
Chamber pressure: 100 mT
RF-power (upper portion): 500 W
RF-power (lower portion): 300 W
CHF₃ gas flow rate: 30 sccm
CF₄ gas flow rate: 170 sccm
Time: 40 sec

The cross section of the pattern formed in the SiO₂ film was observed with an electron microscope (SU8600) manufactured by Hitachi High-Tech Corporation, and the profiles were compared and summarized in Table 12.

**[Table 12]**

| | Composition for forming organic film | Pattern profile after development | Profile after etching for transferring to middle layer film | Profile after etching for transferring to underlayer film | Profile after etching for transferring to substrate | Critical dimension of pattern without twisting after etching for transferring to substrate (nm) |
|---|---|---|---|---|---|---|
| Example 4-1 | UDL-1 | Vertical profile | Vertical profile | Vertical profile | Vertical profile | 21.2 |
| Example 4-2 | UDL-2 | Vertical profile | Vertical profile | Vertical profile | Vertical profile | 20.9 |
| Example 4-3 | UDL-3 | Vertical profile | Vertical profile | Vertical profile | Vertical profile | 19.7 |
| Example 4-4 | UDL-4 | Vertical profile | Vertical profile | Vertical profile | Vertical profile | 20.7 |
| Example 4-5 | UDL-5 | Vertical profile | Vertical profile | Vertical profile | Vertical profile | 18.9 |
| Example 4-6 | UDL-6 | Vertical profile | Vertical profile | Vertical profile | Vertical profile | 20.1 |
| Example 4-7 | UDL-7 | Vertical profile | Vertical profile | Vertical profile | Vertical profile | 19.6 |
| Example 4-8 | UDL-8 | Vertical profile | Vertical profile | Vertical profile | Vertical profile | 19.1 |
| Example 4-9 | UDL-9 | Vertical profile | Vertical profile | Vertical profile | Vertical profile | 19.8 |
| Example 4-10 | UDL-10 | Vertical profile | Vertical profile | Vertical profile | Vertical profile | 24.7 |
| Example 4-11 | UDL-11 | Vertical profile | Vertical profile | Vertical profile | Vertical profile | 23.5 |
| Example 4-12 | UDL-12 | Vertical profile | Vertical profile | Vertical profile | Vertical profile | 23.4 |
| Example 4-13 | UDL-13 | Vertical profile | Vertical profile | Vertical profile | Vertical profile | 19.7 |
| Example 4-14 | UDL-14 | Vertical profile | Vertical profile | Vertical profile | Vertical profile | 18.3 |
| Example 4-15 | UDL-15 | Vertical profile | Vertical profile | Vertical profile | Vertical profile | 18.8 |
| Example 4-16 | UDL-16 | Vertical profile | Vertical profile | Vertical profile | Vertical profile | 20.3 |
| Example 4-17 | UDL-17 | Vertical profile | Vertical profile | Vertical profile | Vertical profile | 20.7 |
| Example 4-18 | UDL-18 | Vertical profile | Vertical profile | Vertical profile | Vertical profile | 20.5 |
| Example 4-19 | UDL-19 | Vertical profile | Vertical profile | Vertical profile | Vertical profile | 22.8 |
| Example 4-20 | UDL-20 | Vertical profile | Vertical profile | Vertical profile | Vertical profile | 18.9 |
| Example 4-21 | UDL-21 | Vertical profile | Vertical profile | Vertical profile | Vertical profile | 20.7 |
| Example 4-22 | UDL-22 | Vertical profile | Vertical profile | Vertical profile | Vertical profile | 24.5 |
| Example 4-23 | UDL-23 | Vertical profile | Vertical profile | Vertical profile | Vertical profile | 24.9 |
| Example 4-24 | UDL-24 | Vertical profile | Vertical profile | Vertical profile | Vertical profile | 19.9 |
| Example 4-25 | UDL-25 | Vertical profile | Vertical profile | Vertical profile | Vertical profile | 19.8 |
| Example 4-26 | UDL-26 | Vertical profile | Vertical profile | Vertical profile | Vertical profile | 18.1 |
| Example 4-27 | UDL-27 | Vertical profile | Vertical profile | Vertical profile | Vertical profile | 18.5 |
| Example 4-28 | UDL-28 | Vertical profile | Vertical profile | Vertical profile | Vertical profile | 20.8 |
| Example 4-29 | UDL-29 | Vertical profile | Vertical profile | Vertical profile | Vertical profile | 23.7 |
| Comparative Example 4-1 | Comparative UDL-1 | Vertical profile | Vertical profile | Vertical profile | Vertical profile | 25.6 |
| Comparative Example 4-2 | Comparative UDL-4 | Vertical profile | Vertical profile | Vertical profile | Vertical profile | 28.5 |
| Comparative Example 4-3 | Comparative UDL-5 | Vertical profile | Vertical profile | Vertical profile | Vertical profile | 34.1 |

As in the results of Examples 4-1 to 4-29 shown in Table 12, when organic films formed using the inventive compositions UDL-1 to -29 for forming an organic film were used as organic films of 3-layer resists for lithography, the resist profile after development was favorable in the pattern profile evaluation, and it can be seen that the inventive compositions for forming an organic film have a useful effect for forming an organic film.

Regarding the pattern profile after etching, in Examples 4-1 to 4-29, the resist profile after development and the profiles of the underlayer film after dry etching and after etching for processing the substrate were all favorable. The pattern size after transferring to the substrate changed in accordance with the width of the resist line formed by exposure, and in Comparative Example 4-3, where a polymer into which fluorine was introduced was used, pattern twisting occurred at a line width of about 34 nm. However, in Examples 4-1 to 4-29, where the inventive compositions for forming an organic film were used, no twisting occurred for pattern sizes of 25 nm and smaller, and it was found that the inventive compositions had high twisting resistance. This is assumed to result from the fact that denser and harder films were formed from the inventive composition for forming an organic film, as can be seen from the results of Example 3. Furthermore, in comparison with Comparative Examples 4-1 and 4-2, where used were comparative UDL-1 and UDL-4, each containing a polymer having no fluorine substituents, in the cases where organic films of the inventive compositions UDL-1 to UDL-29 for forming an organic film were formed under the same baking temperature conditions, it can be seen that the organic films of the present invention, into which fluorine substituents had been introduced, were excellent in twisting resistance. Particularly, in Examples 4-22, 4-23, and 4-29, where UDL-22, -23, and -29 were treated by baking at 250°C, the same level of twisting resistance was exhibited as in Comparative Example 4-1, where a dense film was formed using comparative UDL-1 at a higher temperature, and the advantageous effect of introducing a fluorine substituent can be clearly observed. From these results, it can be seen that the inventive composition for forming an organic film makes it possible to form a dense and strong film, and form an organic film useful as an organic film for a 3-layer or 4-layer resist method having excellent twisting resistance by virtue of a fluorine substituent.

### Example 5: Planarizing Property Evaluation (Examples 5-1 to 5-7)

Each of the compositions (UDL-8, -14, -15, -23, - 26, -27, -28) for forming an organic film was applied respectively onto an SiO₂ wafer substrate having a giant isolated trench pattern (trench width: 10 µm, trench depth: 0.10 µm), and the coating film was baked in the atmosphere under the same conditions as in Example 1 to form each organic film. After each organic film was formed, the step (delta in FIG. 2) between the trench portion and the non-trench portion of the organic film was observed using AFM5500M manufactured by Hitachi High-Tech Corporation. The results are shown in Table 13. In this evaluation, the smaller the step, the better the planarizing property. Note that, in this evaluation, a trench pattern having a depth of 0.10 µm was generally planarized using an organic film material at a film thickness of approximately 0.2 µm. This is a severe evaluation condition to evaluate the planarizing property.

**[Table 13]**

| | Composition for forming organic film | Step (nm) |
|---|---|---|
| Example 5-1 | UDL-8 | 75 |
| Example 5-2 | UDL-14 | 80 |
| Example 5-3 | UDL-15 | 75 |
| Example 5-4 | UDL-23 | 65 |
| Example 5-5 | UDL-26 | 65 |
| Example 5-6 | UDL-27 | 70 |
| Example 5-7 | UDL-28 | 60 |

As shown in Table 13, the inventive compositions for forming an organic film can provide improved flatness by virtue of the addition of a high-boiling-point solvent as in the pair of Examples 5-1 and 5-5, the pair of Examples 5-2 and 5-6, and the pair of Examples 5-4 and 5-7. In particular, comparing Example 5-4 with Example 5-7, it can be seen that, in Example 5-7, flatness was improved even when the same polymer was used and baking was performed at a higher temperature, and even under conditions expected to cause densification of the film by crosslinking and cause film shrinkage due to heat. Furthermore, comparing Example 5-2 with Example 5-3, it can be seen that flatness can be improved by using a polymer having a heat- or acid-labile group. Furthermore, comparing Example 5-1 with Example 5-4, it can be seen that thermal flowability was imparted by the action of the substituent, and flatness was improved. As in the results of Example 4, there is no difference in the twisting resistance of the film, and therefore, it can be seen that flatness can also be improved by the action of the substituent.

### Example 6: Film-Formability Evaluation (Examples 6-1, 6-2, Comparative Example 6-1)

Each of the resist underlayer film materials (UDL-24, UDL-25, comparative UDL-4) prepared above were applied onto each of a bare-Si substrate, a substrate treated with hexamethyldisilazane (HMDS), and a substrate treated with SiON, shown in Table 14, and each coating film was baked under the same baking conditions as in Example 1 to form a 100-nm thick organic film (resist underlayer film). Each of the formed organic films was observed using an optical microscope (ECLIPSE L200 manufactured by NIKON CORPORATION) to check for coating abnormality. Note that, in this evaluation, the film thickness if made thin to evaluate the coating property, and this is a severe evaluation condition, under which film formation abnormality occurs easily. The results are shown in Table 14.

**[Table 14]**

| | Composition for forming organic film | Bare-Si substrate | Substrate treated with HMDS | Substrate treated with SiON |
|---|---|---|---|---|
| Example 6-1 | UDL-24 | No abnormality | No abnormality | No abnormality |
| Example 6-2 | UDL-25 | No abnormality | No abnormality | No abnormality |
| Comparative Example 6-1 | Comparative UDL-4 | No abnormality | Some pinhole defects | Some pinhole defects |

As shown in Table 14, in Comparative Example 6-1, where a polymer having a similar substituent was used, film formation abnormality of pinhole defects was observed on the HMDS-treated substrate and the SiON-treated substrate. On the other hand, in each of Examples 6-1 and 6-2, film-formability was achieved for every substrate. In Example 6-1, a substituent that generates hydroxy groups by virtue of heat or acid is present, and phenolic hydroxy groups are generated during film formation; meanwhile, in Example 6-2, phenolic hydroxy groups are adjusted in an appropriate range beforehand. By virtue of these effects, film-formability was achieved in each of Examples 6-1 and 6-2 of the present invention regardless of the type of substrate, and it can be seen that film-formability was improved. According to the above results, by adjusting the substituents in the repeating unit of the polymer in accordance with the desired performance, the inventive composition for forming an organic film makes it possible to form an organic film even better in not only twisting resistance but also film-formability. Therefore, the inventive composition for forming an organic film can be expected to be a material having an excellent process margin when used for forming an organic film in a 3-layer or 4-layer resist method.

As described above, the inventive composition for forming an organic film is extremely useful for an organic underlayer film, being excellent in twisting resistance at the time of etching, for a multilayer resist process, in particular, a 3-layer resist process, for ultrafine, high-precision patterning.

The present description includes the following embodiments.
[1] A composition for forming an organic film, comprising:
   a polymer having, as a repeating unit, a unit represented by the following general formula (1); and
   an organic solvent, 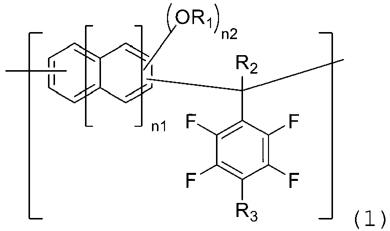
   wherein "n1" represents 0 or 1, "n2" represents an integer of 1 to 3, R₁ represents a hydrogen atom or an alkynyl group having 2 to 4 carbon atoms, R₂ represents a hydrogen atom or a methyl group, and R₃ represents a group selected from the following formulae (2), 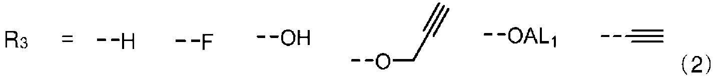
   wherein AL₁ represents a leaving group that generates a hydroxy group by an action of heat or an acid.
[2] The composition for forming an organic film according to [1], wherein the R₂ in the general formula (1) of the polymer is a hydrogen atom.
[3] The composition for forming an organic film according to [1] or [2], wherein a number "n2" of a substituent represented by OR₁ in the general formula (1) of the polymer is 2 or 3.
[4] The composition for forming an organic film according to any one of [1] to [3], wherein the group represented by the R₃ in the general formula (1) of the polymer is selected from the following formulae (3). 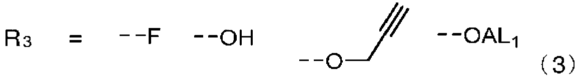
[5] The composition for forming an organic film according to any one of [1] to [4], wherein the polymer has a weight-average molecular weight of 2000 to 10000.
[6] The composition for forming an organic film according to any one of [1] to [5], wherein the organic solvent is a mixture of one or more kinds of organic solvent having a boiling point of lower than 180°C and one or more kinds of organic solvent having a boiling point of 180°C or higher.
[7] The composition for forming an organic film according to any one of [1] to [6], further comprising one or more of a surfactant and a plasticizer.
[8] A patterning process comprising:
   forming an organic film on a body to be processed by using the composition for forming an organic film according to any one of [1] to [7];
   forming a silicon-containing resist middle layer film on the organic film by using a silicon-containing resist middle layer film material;
   forming a resist upper layer film on the silicon-containing resist middle layer film by using a photoresist composition;
   forming a circuit pattern in the resist upper layer film;
   transferring the pattern to the silicon-containing resist middle layer film by etching while using the resist upper layer film having the formed pattern as a mask;
   transferring the pattern to the organic film by etching while using the silicon-containing resist middle layer film having the transferred pattern as a mask; and
   further forming the pattern in the body to be processed by etching while using the organic film having the transferred pattern as a mask.
[9] A patterning process comprising:
   forming an organic film on a body to be processed by using the composition for forming an organic film according to any one of [1] to [7];
   forming a silicon-containing resist middle layer film on the organic film by using a silicon-containing resist middle layer film material;
   forming an organic antireflective coating on the silicon-containing resist middle layer film;
   forming a resist upper layer film on the organic antireflective coating by using a photoresist composition, so that a 4-layered film structure is constructed;
   forming a circuit pattern in the resist upper layer film;
   transferring the pattern to the organic antireflective coating and the silicon-containing resist middle layer film by etching while using the resist upper layer film having the formed pattern as a mask;
   transferring the pattern to the organic film by etching while using the silicon-containing resist middle layer film having the transferred pattern as a mask; and
   further forming the pattern in the body to be processed by etching the body to be processed while using the organic film having the transferred pattern as a mask.
[10] A patterning process comprising:
   forming an organic film on a body to be processed by using the composition for forming an organic film according to any one of [1] to [7];
   forming an inorganic hard mask selected from the group consisting of a silicon oxide film, a silicon nitride film, and a silicon oxynitride film on the organic film;
   forming a resist upper layer film on the inorganic hard mask by using a photoresist composition;
   forming a circuit pattern in the resist upper layer film;
   transferring the pattern to the inorganic hard mask by etching while using the resist upper layer film having the formed pattern as a mask;
   transferring the pattern to the organic film by etching while using the inorganic hard mask having the transferred pattern as a mask; and
   further forming the pattern in the body to be processed by etching the body to be processed while using the organic film having the transferred pattern as a mask.
[11] A patterning process comprising:
   forming an organic film on a body to be processed by using the composition for forming an organic film according to any one of [1] to [7];
   forming an inorganic hard mask selected from the group consisting of a silicon oxide film, a silicon nitride film, and a silicon oxynitride film on the organic film;
   forming an organic antireflective coating on the inorganic hard mask;
   forming a resist upper layer film on the organic antireflective coating by using a photoresist composition, so that a 4-layered film structure is constructed;
   forming a circuit pattern in the resist upper layer film;
   transferring the pattern to the organic antireflective coating and the inorganic hard mask by etching while using the resist upper layer film having the formed pattern as a mask;
   transferring the pattern to the organic film by etching while using the inorganic hard mask having the transferred pattern as a mask; and
   further forming the pattern in the body to be processed by etching the body to be processed while using the organic film having the transferred pattern as a mask.
[12] The patterning process according to [10] or [11], wherein the inorganic hard mask is formed by a CVD method or an ALD method.
[13] The patterning process according to any one of [8] to [12], wherein the circuit pattern is formed by a lithography using light with a wavelength of 10 nm or more to 300 nm or less, a direct drawing with electron beam, nanoimprinting, or a combination thereof.
[14] The patterning process according to any one of [8] to [13], wherein the circuit pattern is developed by alkali development or with an organic solvent.
[15] The patterning process according to any one of [8] to [14], wherein the body to be processed is a semiconductor device substrate, a metal film, a metal carbide film, a metal oxide film, a metal nitride film, a metal oxycarbide film, or a metal oxynitride film.
[16] The patterning process according to [15], wherein the metal is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising:
a polymer having, as a repeating unit, a unit represented by the following general formula (1); and
an organic solvent, 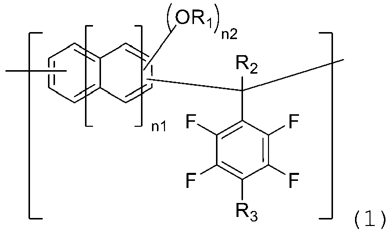
wherein "n1" represents 0 or 1, "n2" represents an integer of 1 to 3, R₁ represents a hydrogen atom or an alkynyl group having 2 to 4 carbon atoms, R₂ represents a hydrogen atom or a methyl group, and R₃ represents a group selected from the following formulae (2), 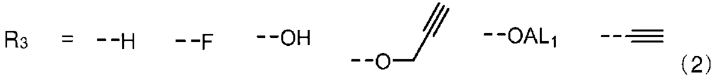
wherein AL₁ represents a leaving group that generates a hydroxy group by an action of heat or an acid.

2. The composition for forming an organic film according to claim 1, wherein the R₂ in the general formula (1) of the polymer is a hydrogen atom.

3. The composition for forming an organic film according to claim 1 or 2, wherein a number "n2" of a substituent represented by OR₁ in the general formula (1) of the polymer is 2 or 3.

4. The composition for forming an organic film according to any one of claims 1 to 3, wherein the group represented by the R₃ in the general formula (1) of the polymer is selected from the following formulae (3).

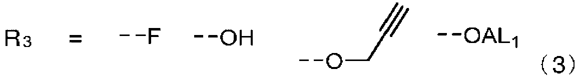

5. The composition for forming an organic film according to any one of claims 1 to 4, wherein the polymer has a weight-average molecular weight of 2000 to 10000.

6. The composition for forming an organic film according to any one of claims 1 to 5, wherein the organic solvent is a mixture of one or more kinds of organic solvent having a boiling point of lower than 180°C and one or more kinds of organic solvent having a boiling point of 180°C or higher.

7. The composition for forming an organic film according to any one of claims 1 to 6, further comprising one or more of a surfactant and a plasticizer.

8. A patterning process comprising:
forming an organic film on a body to be processed by using the composition for forming an organic film according to any one of claims 1 to 7;
forming a silicon-containing resist middle layer film on the organic film by using a silicon-containing resist middle layer film material;
forming a resist upper layer film on the silicon-containing resist middle layer film by using a photoresist composition;
forming a circuit pattern in the resist upper layer film;
transferring the pattern to the silicon-containing resist middle layer film by etching while using the resist upper layer film having the formed pattern as a mask;
transferring the pattern to the organic film by etching while using the silicon-containing resist middle layer film having the transferred pattern as a mask; and
further forming the pattern in the body to be processed by etching while using the organic film having the transferred pattern as a mask.

9. A patterning process comprising:
forming an organic film on a body to be processed by using the composition for forming an organic film according to any one of claims 1 to 7;
forming a silicon-containing resist middle layer film on the organic film by using a silicon-containing resist middle layer film material;
forming an organic antireflective coating on the silicon-containing resist middle layer film;
forming a resist upper layer film on the organic antireflective coating by using a photoresist composition, so that a 4-layered film structure is constructed;
forming a circuit pattern in the resist upper layer film;
transferring the pattern to the organic antireflective coating and the silicon-containing resist middle layer film by etching while using the resist upper layer film having the formed pattern as a mask;
transferring the pattern to the organic film by etching while using the silicon-containing resist middle layer film having the transferred pattern as a mask; and
further forming the pattern in the body to be processed by etching the body to be processed while using the organic film having the transferred pattern as a mask.

10. A patterning process comprising:
forming an organic film on a body to be processed by using the composition for forming an organic film according to any one of claims 1 to 7;
forming an inorganic hard mask selected from the group consisting of a silicon oxide film, a silicon nitride film, and a silicon oxynitride film on the organic film;
forming a resist upper layer film on the inorganic hard mask by using a photoresist composition;
forming a circuit pattern in the resist upper layer film;
transferring the pattern to the inorganic hard mask by etching while using the resist upper layer film having the formed pattern as a mask;
transferring the pattern to the organic film by etching while using the inorganic hard mask having the transferred pattern as a mask; and
further forming the pattern in the body to be processed by etching the body to be processed while using the organic film having the transferred pattern as a mask,
preferably wherein the inorganic hard mask is formed by a CVD method or an ALD method.

11. A patterning process comprising:
forming an organic film on a body to be processed by using the composition for forming an organic film according to any one of claims 1 to 7;
forming an inorganic hard mask selected from the group consisting of a silicon oxide film, a silicon nitride film, and a silicon oxynitride film on the organic film;
forming an organic antireflective coating on the inorganic hard mask;
forming a resist upper layer film on the organic antireflective coating by using a photoresist composition, so that a 4-layered film structure is constructed;
forming a circuit pattern in the resist upper layer film;
transferring the pattern to the organic antireflective coating and the inorganic hard mask by etching while using the resist upper layer film having the formed pattern as a mask;
transferring the pattern to the organic film by etching while using the inorganic hard mask having the transferred pattern as a mask; and
further forming the pattern in the body to be processed by etching the body to be processed while using the organic film having the transferred pattern as a mask,
preferably wherein the inorganic hard mask is formed by a CVD method or an ALD method.

12. The patterning process according to any one of claims 8 to 11, wherein the circuit pattern is formed by a lithography using light with a wavelength of 10 nm or more to 300 nm or less, a direct drawing with electron beam, nanoimprinting, or a combination thereof.

13. The patterning process according to any one of claims 8 to 12, wherein the circuit pattern is developed by alkali development or with an organic solvent.

14. The patterning process according to any one of claims 8 to 13, wherein the body to be processed is a semiconductor device substrate, a metal film, a metal carbide film, a metal oxide film, a metal nitride film, a metal oxycarbide film, or a metal oxynitride film.

15. The patterning process according to claim 14, wherein the metal is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
